# EUROPEAN PATENT APPLICATION

(11) **EP 0 877 329 A1**
(43) Date of publication of application: **11.11.1998**
(21) Application number: 97900107.0
(22) Date of filing: 08.01.1997
(51) Int. Cl.: G06F 17/50

(54) **GENERATION METHOD AND USAGE OF LOGIC MODELS, APPARATUS FOR THE METHODS AND DATA STRUCTURE**

(30) Priority: 10.01.1996 JP 28386/96
(71) Applicant: Athena Telecom Lab, Inc., Koganei-shi, Tokyo 184 (JP)
(72) Inventor: KAMIMURA, Kunio, Koganei-shi, Tokyo 184 (JP)
(74) Representative: Desrousseaux, Grégoire Marie
(86) International application number: JP9700013
(87) International publication number: WO9725680

(57) **Abstract**

Logic models expressing various objects in the real world can be handled by using a computer, but when a plurality of logic models have mutual relationship of the requirement of services and offering of the services, it has been difficult to generate all the details of the associated logic models without contradiction. To solve the problem, those services which are accomplished by the operation of a plurality of elements (model components) are expressed as service model components which are the same as the elements existing in practice, and the associated logic models are interconnected by using them. Further, it is intended to provide a method of generating associated logic models without contradiction, an apparatus therefor, a method of, and an apparatus for, "deleting model components without causing contradiction" and "searching characteristic values and evaluating the influences of the characteristic values with high fidelity to the structure of the logic model" by utilizing the logic models the model components of which are coupled by reference. These methods are embodied in programs and models which can be stored in a computer-readable medium.

## Description

### TECHNICAL FIELD

Computers can be used to reproduce real-world arrangements with the aid of memory. This approach is called logical modeling. The subject invention presents a method for generating logical models, an apparatus for generating logical models, a data structure for a logical model generated thereby, a method for utilizing a logical model, and an apparatus for utilizing a logical model. Designs for communications networks, transportation plans, human and organizational interrelationship diagrams, and architectural designs are referred to as examples included herein.

### BACKGROUND ART

As aforementioned, computer memory can be utilized to reproduce real world arrangements. Drawing architectural or car designs, or designing engines using the CAD system is in fact already founded on the principle of generating logical models in the computer. Different models often represent same things according to different points of view. If the subject concept is rough, then a rough logical model is generated, and if the subject concept is detailed, then a detailed logical model is generated in turn. In various instances, such as architecture, many designs ranging from rough to detailed plans are inevitable. It is difficult to manage such design plans when generating or modifying them without contradictions among these plans. For example, the details of an engine are not represented by the design of the car, but by the design of the engine itself. When the engine design is modified, it is very difficult to evaluate precisely how the general design of the car is effected and how to modify the car's design without contradicting the modified engine design. Conventional systems for generating logical models can handle only one logical model at a time, and have difficulty in generating plans where interrelationships between plural logical models are in consideration.

The same applies for communication network design drawings. In general, only one communications networks has been designed. In other words, communication points and circuits connecting each communication point are selected, and then the relevant apparatus to implement each communication point is specified. Although there appears to be only one circuit as seen from the user's side, the entire structure is in fact highly complex. In order to see the overall structure, it is necessary to see the design drawing of the communication network from the circuit provider standpoint. A given single circuit provided is actually a collaboration of various internal sub-circuits and communication equipment. As a result, any errors occurring within one communication network affects other networks using communication circuits provided by the original flawed network. Therefore, representation of such instances correctly in the computer is indispensable.

Again, the same can be said for transportation plans. In the global transportation plan covering the world, for example, Tokyo and New York are connected by one air link. However, this one link in fact consists of several, such as transportation necessary to Narita International Airport, the actual air flight between Narita and John F. Kennedy International Airport, and transportation thereon, et cetera. Furthermore, the link representing transportation to Narita International Airport consists of detailed transportation systems. Human and organizational interrelationship diagrams present similar cases. A line connecting the interrelationship between two companies is actually comprised of numerous interrelationships of many individual persons.

A method is necessary to couple rough and detailed models, and to provide a model with requested details. Additionally, a means to adjust a detailed design drawing and successively modify related design drawings unyielding contradiction, is needed.

### DISCLOSURE OF THE INVENTION

### 〈〈Section 1: Model components and their connection by reference〉〉

A logical model consists of relations between the constituent elements and model components, which are the constituent elements of the model. The model elements are data blocks (portions of the memory unit of a computer, groups of elements having a recording function and the like) containing recorded information about the things or concepts of the real world. The phrase "to generate a model component" is to hunt a memory block and to write data onto it. In C++, for example, memory is hunted using a "new" operator, and data are entered in this memory. The hunted memory is generally called an object.

A pointer can represent the connecting relationship among logical models. Given two model components X and Y, the phrase "to set the reference" from X to Y refers to a condition in which the pointer to Y (the main memory address of Y) is recorded in X. Several such reference embodiments are shown in Section 8.2. The term "reference" refers to the condition in which the assigned model component can be accessed by using this data (pointer). A coordinate of matrix can be a reference, when each element of given matrix (is an address of a model component, for example) corresponds to a model component.

In the technical field of the software, "reference" (or "pointer") usually means a memory address. But the usage of the term "reference" herein has a broader concept than just a memory address. Furthermore, the phrases "to connect by reference", or "to associate by reference", mean a condition in which a reference is set.

### 〈〈Section 2: Service Model Components〉〉

In hierarchical logical models, lower logical models provide upper logical networks with services. In models of communications networks, lower communications networks provide communications services and upper communications networks use those communications services as circuits. In transportation plans, lower transportation facilities provide transportation services, and upper transportation plans are drawn up using the lower transportation services. In human and organizational interrelationship diagrams, intangible concepts of companies in upper ranks of the hierarchy are realized in utilizing lower concrete relationships of persons or organizations. In architectural design drawings, lower design drawings provide parts for architectural structures, and upper design drawings of broader viewpoint uses those parts.

From the service-user's point of view, the provided service is an important element to generate a logical model. That is, the service is seen as a model component. On the other hand, as seen from the service provider side, the service is implemented in cooperation of model components inside the logical model, and therefore is not recognized as a model component. As the logical model of design and control target has been only one, this point has not yet to prove itself a problem.

In the present invention, the service that a logical model provides is regarded as a constituent element of the logical model and is called a "service model component". The logical model (that is the lower or the provider side logical model) to provide the service and the logical model (upper or the user side logical model) to use the given service are connected by service model component. In other words, the service model component and the provider side logical model are connected by a reference, and the said service model component and the using-side logical model are also connected by a reference. Although service model components belong to the provider side logical model (see Section 9.4 and FIG. 18, FIG. 19), the phrase "to connect a service model component and the provider side logical model by a reference" is used herein to make the explanation brief and simple (See Section 8.4).

The aforementioned is the first point in describing the present invention. With this idea, the interrelationship of service request-provision can be generated without any contradiction. This idea can be also used to delete model components, search characteristic values, and evaluate the effect of changing characteristic values over plural logical models.

### 〈〈 Section 3: Request Service Model Components and Provision Service Model Components〉〉

Service model components can be classified into two types: the "provision service model component" and the "request service model component" (respectively PSMC and RSMC hereon). Characteristics of the provision service (specifications, price and cost, quality of service and so on) are recorded on the "provision service" model component. Requested conditions of the service are recorded on the "request service" model component.

Section 2 explains a case using only PSMCs. The user side logical model and the provider side logical model are connected, setting a reference between the PSMC and the user side logical model, and setting a reference between the PSMC and the provider side logical model. If the user side logical model and the provider side logical model are connected by the RSMC in addition to the connection by the PSMC, these connections thereof are parallel.

Logical models can also be serially connected, coupling PSMC and RSMC. This is done by setting references each between the requesting-side logical model and RSMC, between the provider side logical model and PSMC, and between RSMC and PSMC.

If given data on both the provision and request service, one can determine whether altered characteristic value of provided service will meet a request or not. For example, assume that two 256kbps circuits are provided for a request of two 64kbps circuits. Even if the circuits on the provider side are changed from two 256kbps lines to that of two 128kbps lines, by checking the two 64kbps circuits of the requesting-side, it can be determined that the circuits on the provider side still meet that request.

### 〈〈 Section 4: Service Sub Models and Actual Sub Models〉〉

It had been very difficult to generate logical models without any contradictions when those models were interrelated. A logical model is generated using service model components provided by other logical models, but such service model components are implemented in cooperation with model components of the provider side logical model. From this point of view, the structure of the provider side logical model is necessary to provide service model components. However, the structure of the provider side logical model cannot be designed without defining the service model components to be implemented as provision services themselves.

Therefore, one logical model is divided into "sub logical models", meaning that a logical model is comprised of a "service sub model" and an "actual sub model". A service sub model is a sub logical model representing a provision service. An actual sub model is a sub logical model representing the concrete structure of the given logical model. FIG. 19 illustrates a service sub model and an actual sub model, and details about them are explained in Section 12.

In generating a logical model, other logical models only provide service model components. According to respective provision services' rules (refer to "provision service data" in Section 9.2), provider side logical models generate service model components and accommodate those service model components in respective service sub models, and provide these service model components to the request side logical model. In a generating stage of a logical model, the provider side logical model generates actual logical models to realize service model components accommodated in respective service sub models. In other words, the process to generate a logical model means the process to generate the relevant actual sub model(s).

These ideas can be used to generate one general model at one time, and then generate all logical models that are interrelated. That is, to generate an entire picture of plural design drawings of communications networks even if they are intricately interrelated, and without any contradictions.

Before designing a logical model, relationships represent plans of the request and the provision of the logical model's service. The details are described in Section 9.1, which introduces the core model component, and in Section 11 (also in Step 1 of FIG.18). Each time a single logical model is generated, the user side logical model and the provider side logical models are concretely connected via the relevant service model component.

### 〈〈Section 5: Deletion of Model Components〉〉

After generating a logical model, some model components can be deleted. For instance, cases arise in which logical models according to different specifications are evaluated, or the effects of failures are evaluated. However, in deleting just the relevant model component causes contradiction with the generated logical model. For example, when an airport becomes unavailable, it is contradictory if air routes concerning that airport are still available. Moreover, it is contradictory if transportation transactions through that airport are still available when the airport itself is not.

Therefore, what this invention does when a model component is to be deleted, is to first trace the reference of the given model component. It then traces other model components relevant to that model component with reference, and determines whether or not contradictions will occur with the deletion of the originally stated model component. If no such contradiction(s) can be determined, the system collectively deletes all the relevant model components. The details are described in Section 13 and Section 17.

### 〈〈Section 6: Search for Characteristic Value, and the Effect Thereof〉〉

To evaluate a logical model, it is necessary to accumulate the characteristic values specified for the model components in accordance with the structure of the logical model. For example, in order to determine error rates in a circuit of a communications network, it is necessary to search for the communications network that provides this circuit and add up the error rates of its constituent elements. It is necessary to trace the relationship that supports the realization of this circuit (that is, to trace back the relation that provides this circuit) and to find the error rates of plural communications networks.

The idea below has been invented in order to handle various characteristic values consistently. The operator enters in the component representing values ("characteristic value component") the label to discriminate kind of characteristic values and the rule in order to accumulate a characteristic value in a component. When the operator assigns a characteristic value component and instructs the search for the characteristic value of the model component, the system traces back the relationship that supports the realization and finds the characteristic value component specified for the model component a priori. The system accumulates values of searched characteristic value components by the specified rule. To prevent an endless search, restrictions, such as a limitation on the number of logical models to be searched are set.

A detailed description of this is shown in Section 14 and Section 18, but is presented in a simplified case where the value of a characteristic value component is directly entered into a model component, without the use of the characteristic value component itself.

When a characteristic value is altered, the system can trace the relationship that supports the realization and evaluate the effects of that change. Details of this are given in Section 15 and Section 19.

### BRIEF EXPLANATION OF DRAWINGS

FIG. 1 Block diagram showing the apparatus, which executes the program that realizes the method for generating and utilizing the hierarchical logical model.

FIG. 2 Block diagram showing the first embodiment of a reference.

FIG. 3 Block diagram showing the second embodiment of a reference.

FIG. 4 Block diagram showing the third embodiment of a reference.

FIG. 5 Block diagram showing the fourth embodiment of a reference.

FIG. 6 Block diagram showing the fifth embodiment of a reference.

FIG. 7 Block diagram showing the sixth embodiment of a reference.

FIG. 8 Flowchart showing the generating logical model method implemented as a computer program.

FIG. 9 Flowchart showing the group of processes associated with basic definitions of logical models.

FIG. 10 Flowchart showing the process for providing a service model component.

FIG. 11 Flowchart showing the process determining the service provision capability when service provision locations and areas are assigned.

FIG. 12 Flowchart showing the process for providing a service model component when services can be provided to any location and area.

FIG. 13 Flowchart showing the structure of the group of processes for generating an actual sub model.

FIG. 14 Flowchart showing the process for determining a base topology of a

two-level hierarchical network.

FIG. 15 Flowchart showing the process for flow assignment.

FIG. 16 Flowchart showing the process for service capacity assignment.

FIG. 17 Flowchart showing the process for system capacity assignment.

FIG. 18 Example 1 of a block diagram for generating a logical model.

FIG. 19 Example 2 of a block diagram for generating a logical model.

FIG. 20 Flowchart showing the process for deleting a model component.

FIG. 21 Flowchart showing the process for searching and accumulating characteristic values. (Unit process for searching and accumulating).

FIG. 22 Flowchart showing the process for evaluating the effect of characteristic values. (The first unit process for evaluating the effect of characteristic value).

FIG. 23 Flowchart showing the second unit process for evaluating the effect of characteristic value.

FIG. 24 Block diagram showing the structure of an apparatus for generating a logical model.

FIG. 25 Block diagram showing the structure of an apparatus for deleting a model component.

FIG. 26 Block diagram showing the structure of an apparatus for searching and accumulating characteristic values.

FIG. 27 Block diagram showing the structure of an apparatus for evaluating the effect of changing a characteristic value.

### THE BEST MODE FOR CARRYING OUT THE INVENTION

### 〈〈Section 7: The Mode for Carrying out the Invention〉〉

### 〈〈Section 7.1: The Mode for Carrying out the Method〉〉

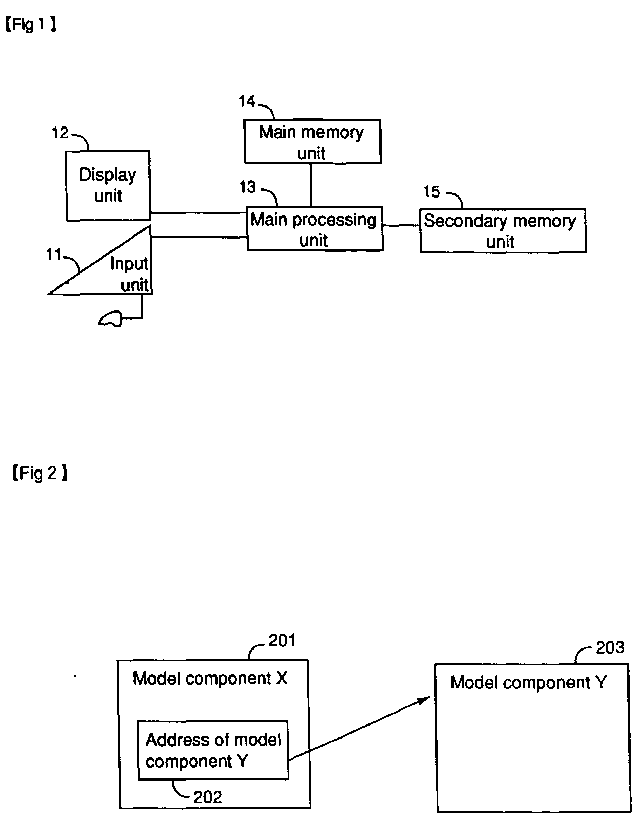

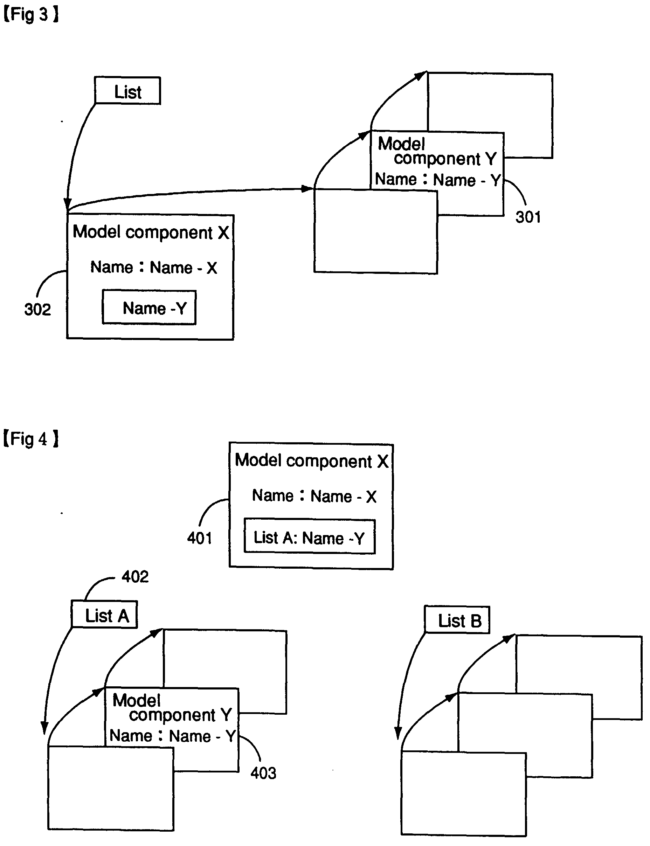

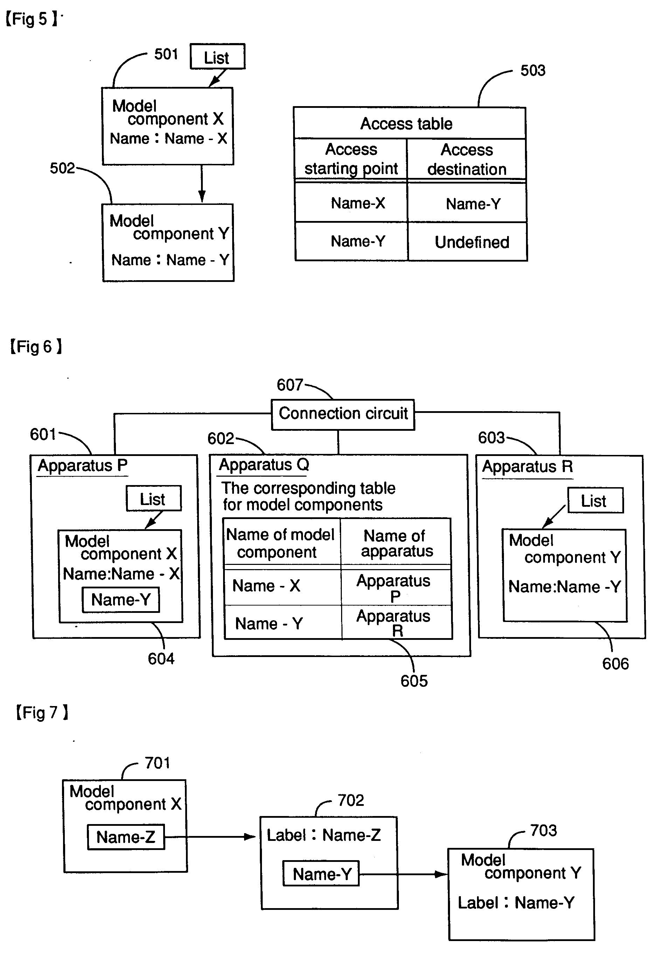

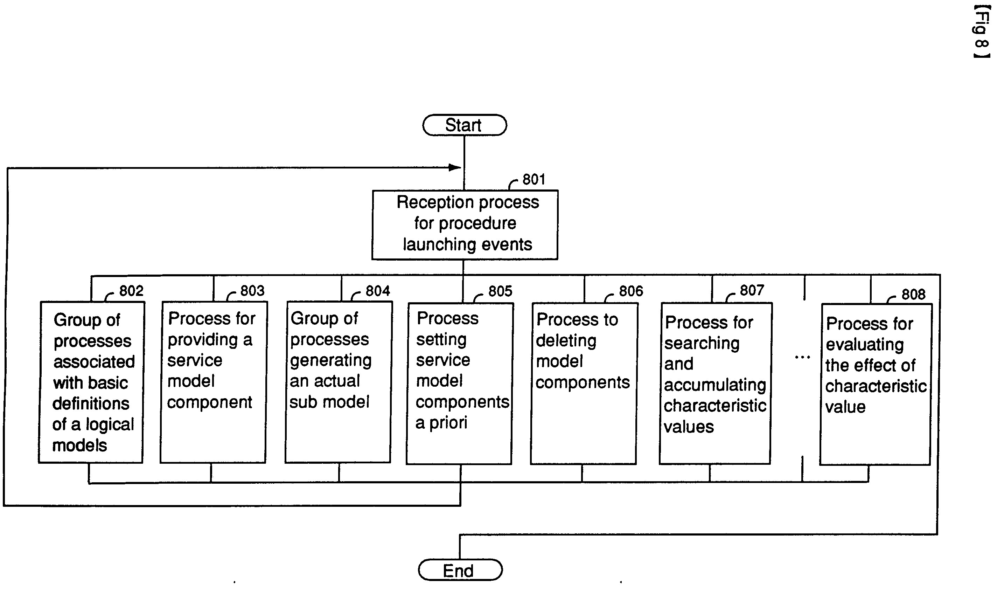

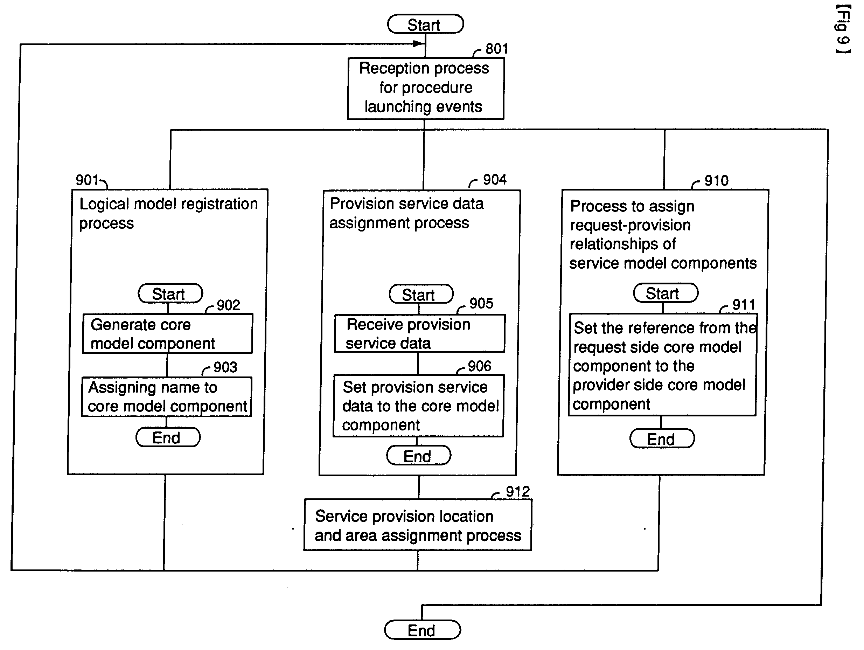

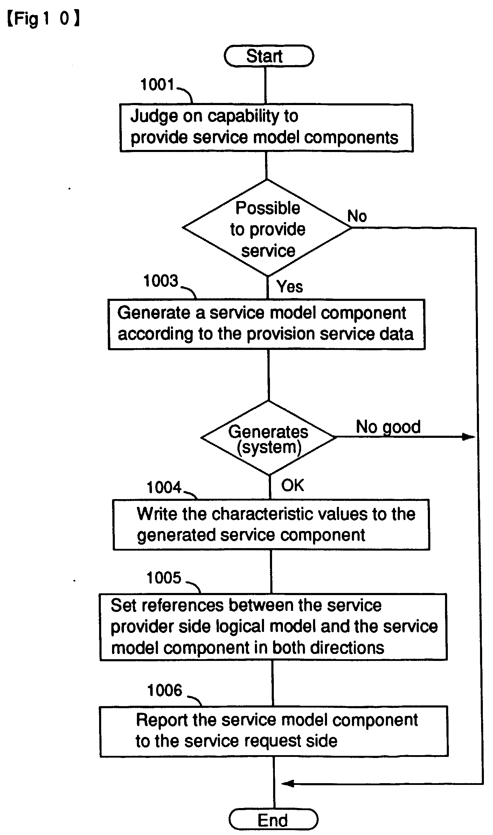

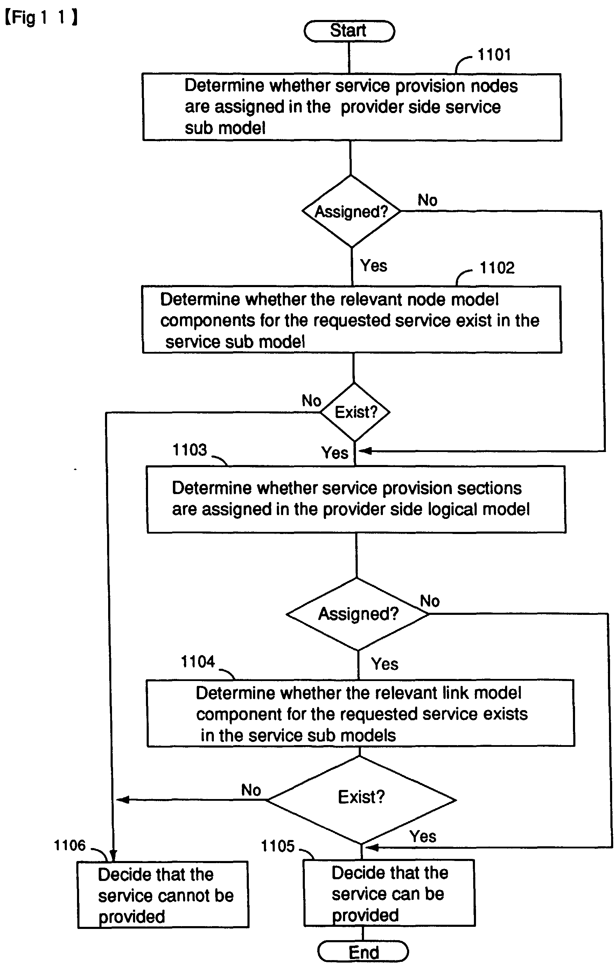

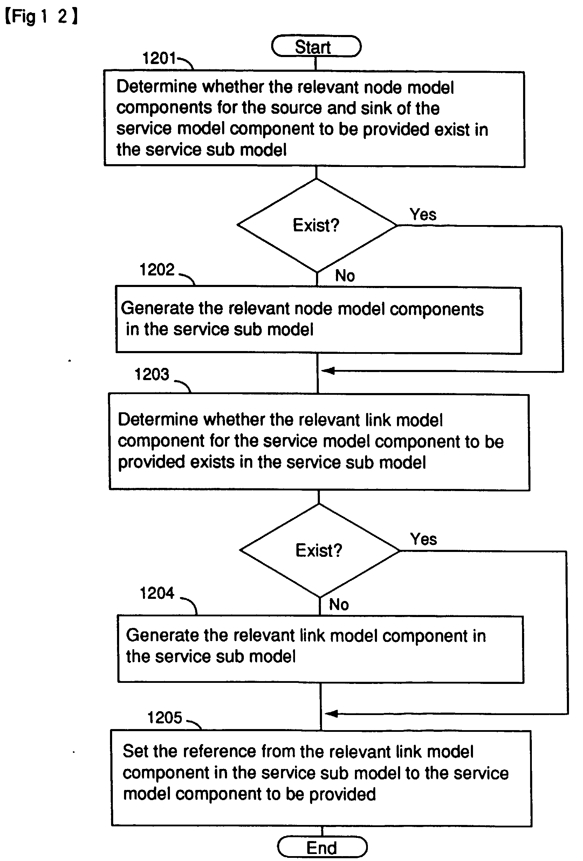

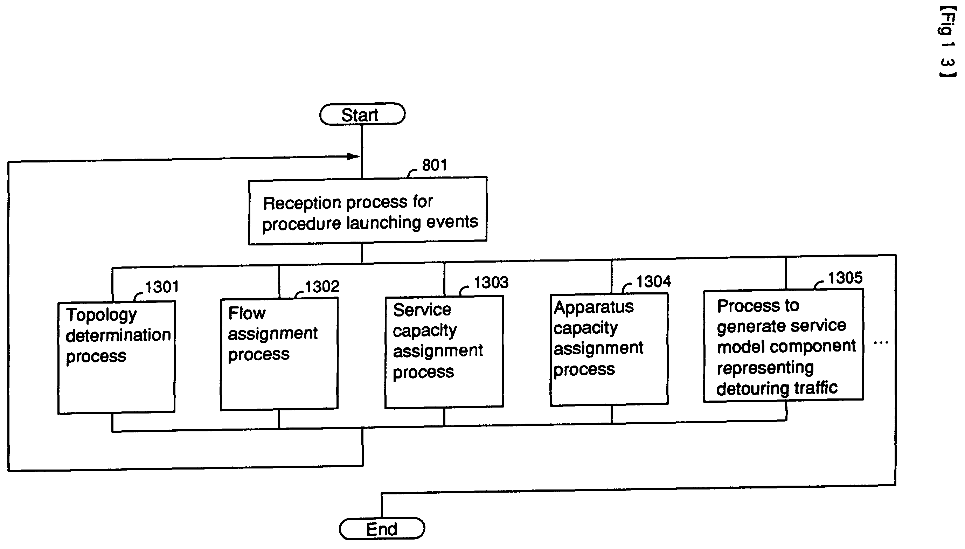

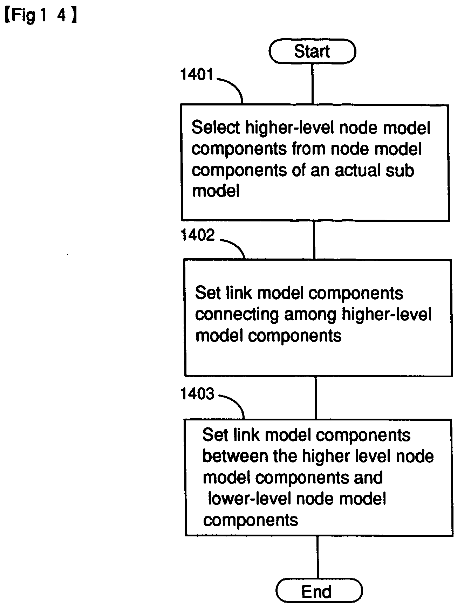

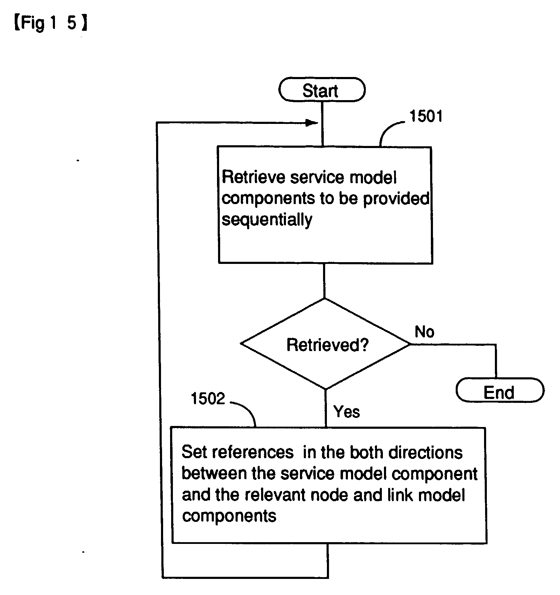

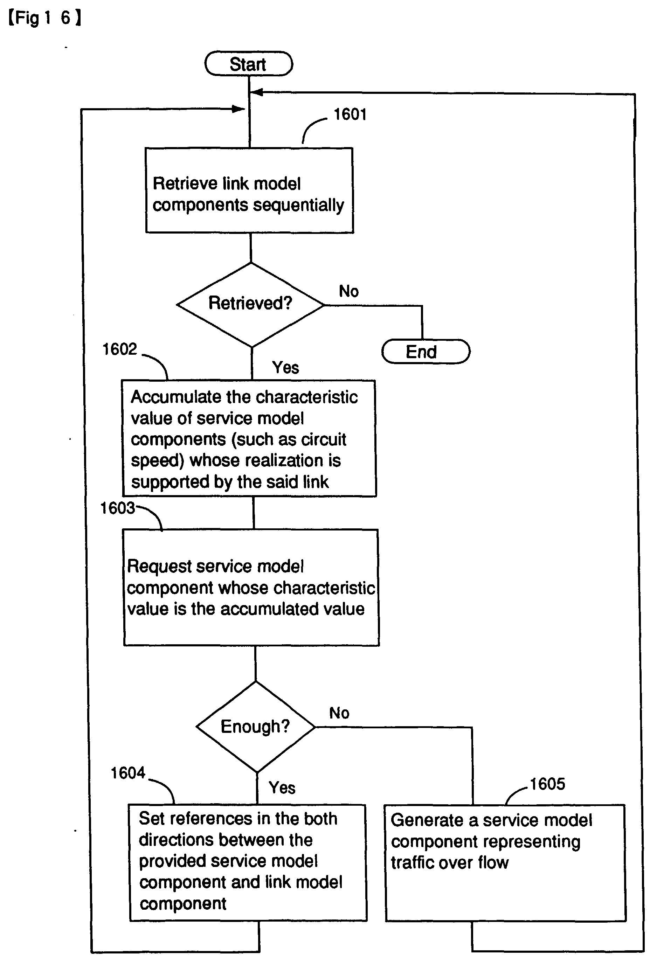

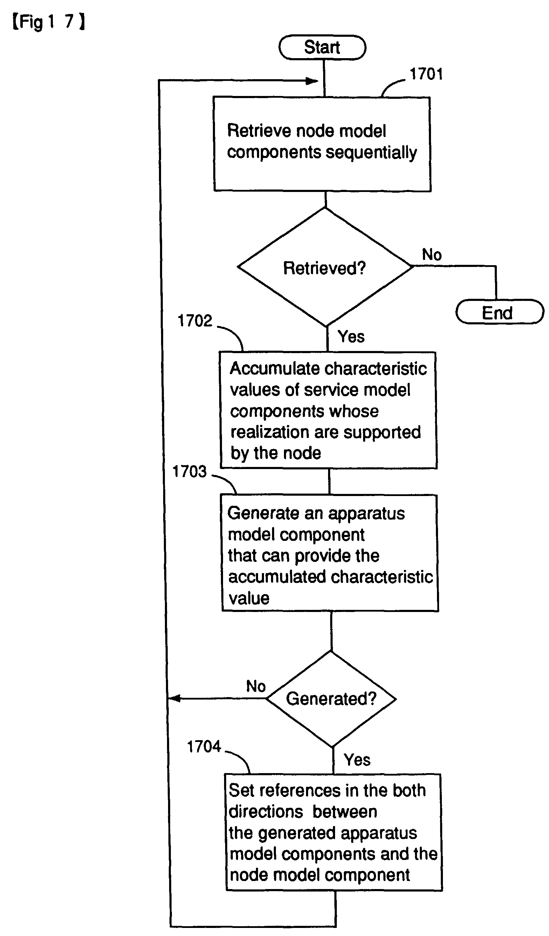

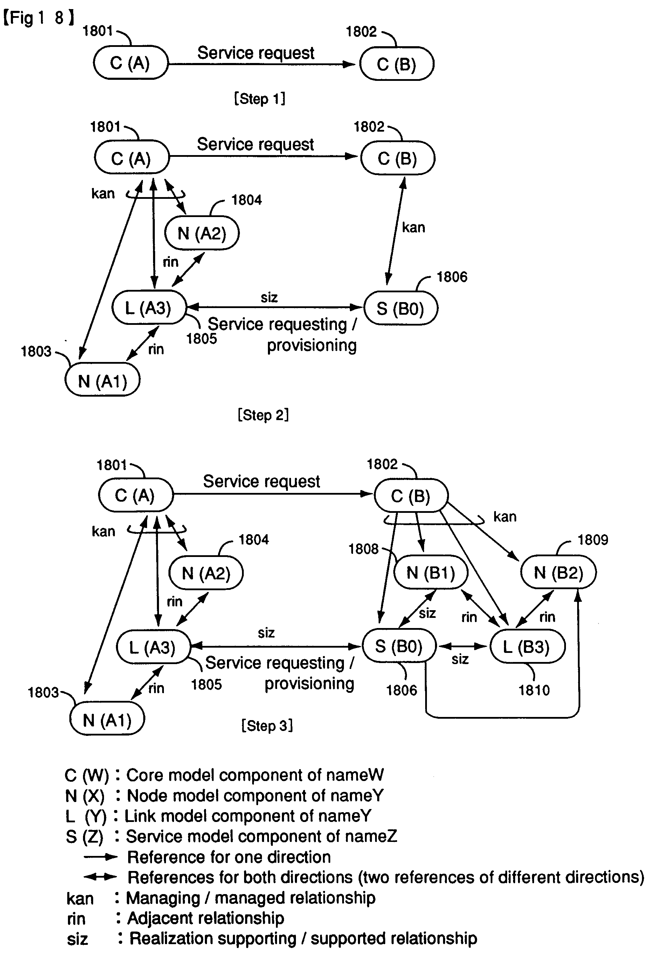

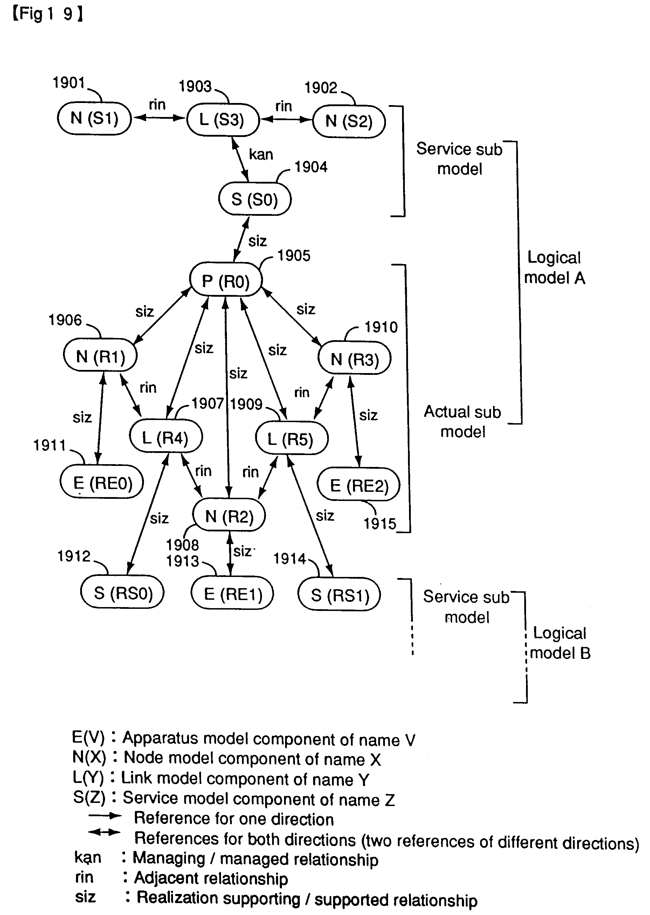

One example to show how to generate and utilize logical models is to realize the given methods as computer programs. The general structure of a computer is illustrated in FIG. 1. The specifications for designing a logical model that have been entered into Input Unit 11 is analyzed in the Main Processing Unit 13, and is recorded in the Main Memory Unit 14. Following this process, a logical model is generated in Main Memory Unit 14. The processing status can be shown on Display Unit 12. The operator evaluates the results as they come, and enters further instruction and data from Input Unit 11. The logical model in the Main Memory Unit 14 is recorded in the Secondary Memory Unit 15, from where it is read whenever the system is re-launched thereon.

These programs are recorded onto computer-readable media such as floppy disks (FD), compact disks (CD), optical disks, and hard disks, and are then distributed as such. Some programs are distributed via communications networks. In most cases, installations are finalized by being recorded in a secondary-memory medium such as the hard disk. In some cases, software is pre-installed in a secondary-memory medium (such as the hard disk) of a computer, and sold as bundled software.

There is also the situation where the operator downloads the program from a communications network, and directly develops it in the main memory, and executes the given program. Java programs are such a case. If the main memory is regarded as a computer-readable medium, it can be thought that this situation is the same as one where a program is installed in a hard disk.

The program realized by the present invention can be launched either in a single computer, or it can be distributed and operated in several computers. The communications network models that these programs generate and utilize can be generated and stored in the main or secondary memory of one computer. They can also be generated and stored in the main memory and the secondary memory of a number of computers.

### 〈〈Section 7.2: The Mode of Implementing Apparatus〉〉

Apparatus for generating and utilizing logical models by the present invention can be implemented singularly or as plural apparatuses working together. Communications network models these apparatuses generate and use can be generated and stored within these apparatuses, and can be applied as such in other plural apparatus. Setting logical mappings between microprocessors or parts of the Integrated Circuit (IC) and communications network models or model components, it is possible to implement an apparatus to generate and hold plural communications network models.

### 〈〈Section 8: Model Components and References〉〉

### 〈〈Section 8.1: Various Kinds of Model Components〉〉

The constituent element of a logical model is the model component. The contents of model components differ depending on what each model component represents. A "node model component" is used to represent a communication point in a communications network model. A "link model component" is used to represent the detailed relationship of connection among node model components. The relationship between a link model component and a node model component is represented by a "reference".

In transportation plans, a node model component represents a point such as transportation starting point, a relay point, or an ending point. A link model component is representative of the transportation between two points. In human or organizational interrelationship diagrams, a node model component represents a person or an organization, and a link model component represents the relationship between the persons or organizations. In architectural design drawings, a node model component is the building material (the unit or collective unit), and a link model component represents the relationship with which those building materials are connected.

Model components other than those mentioned can be introduced. Also, both node and link model components can be utilized in a different manner in the same situation. In architectural design drawings, for example, it is possible for a node model component to specify a place and for the link model component to represent building material.

### 〈〈Section 8.2: Embodiments of References〉〉

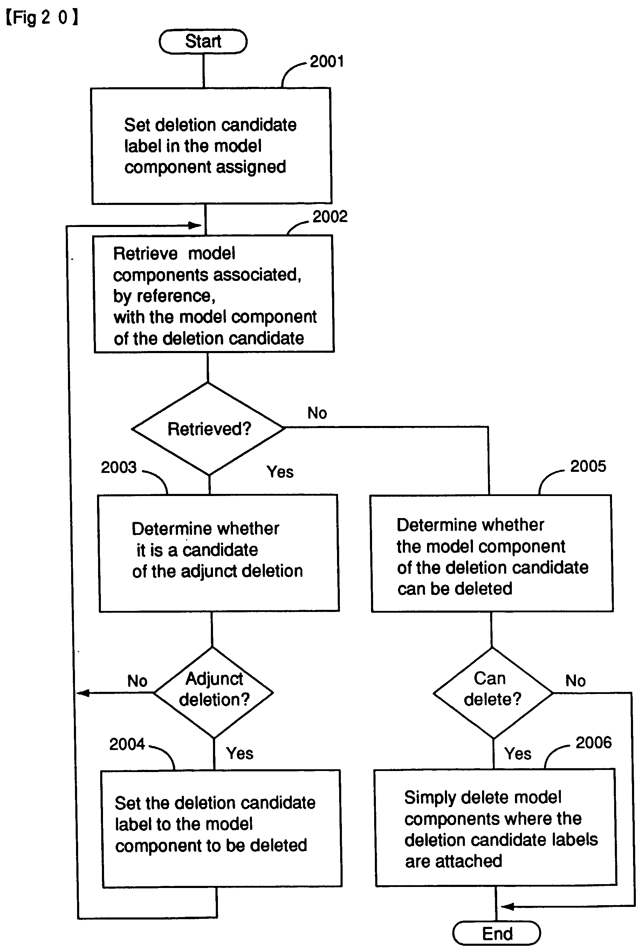

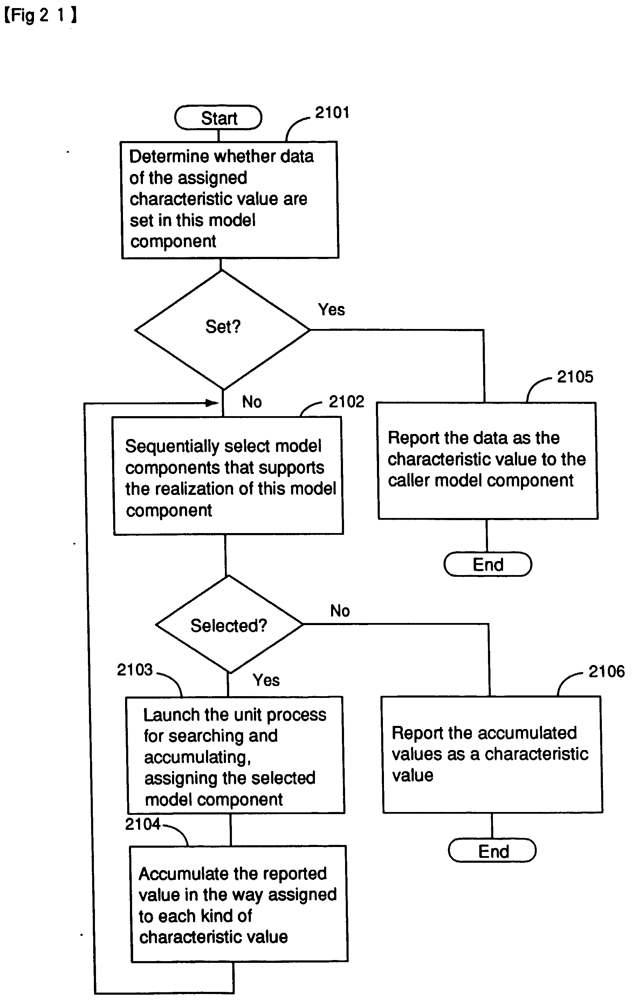

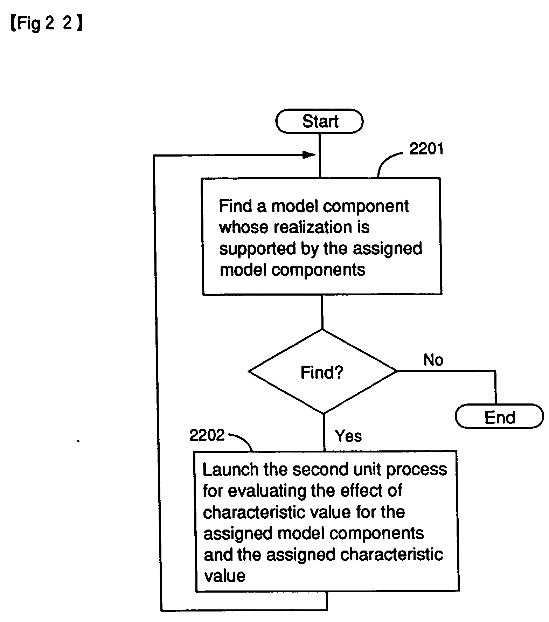

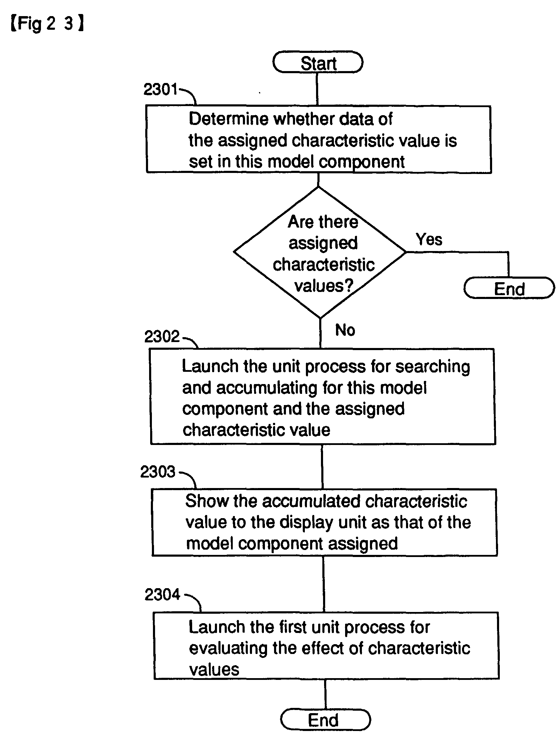

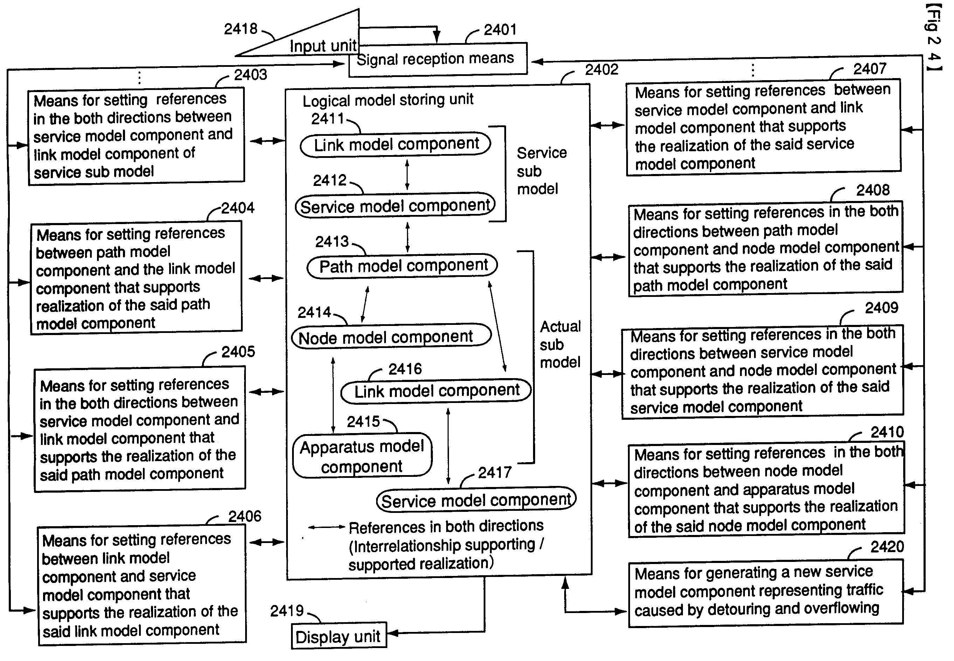

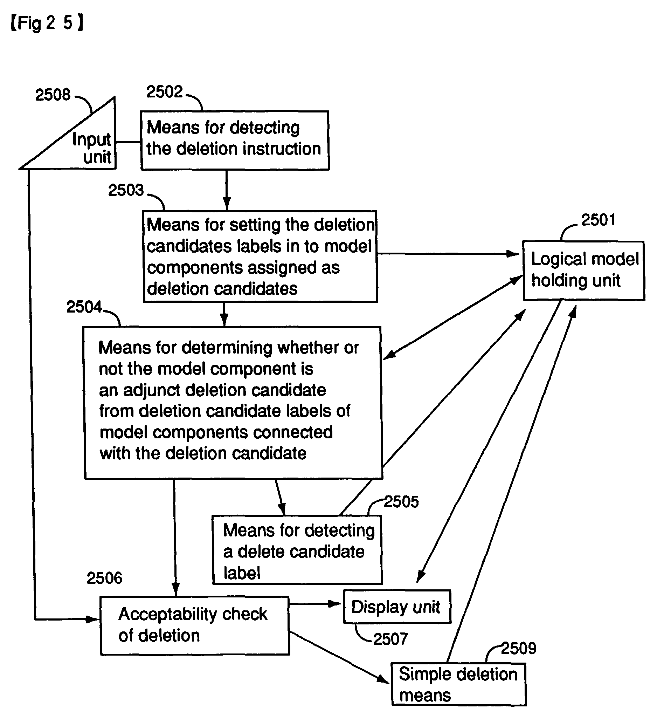

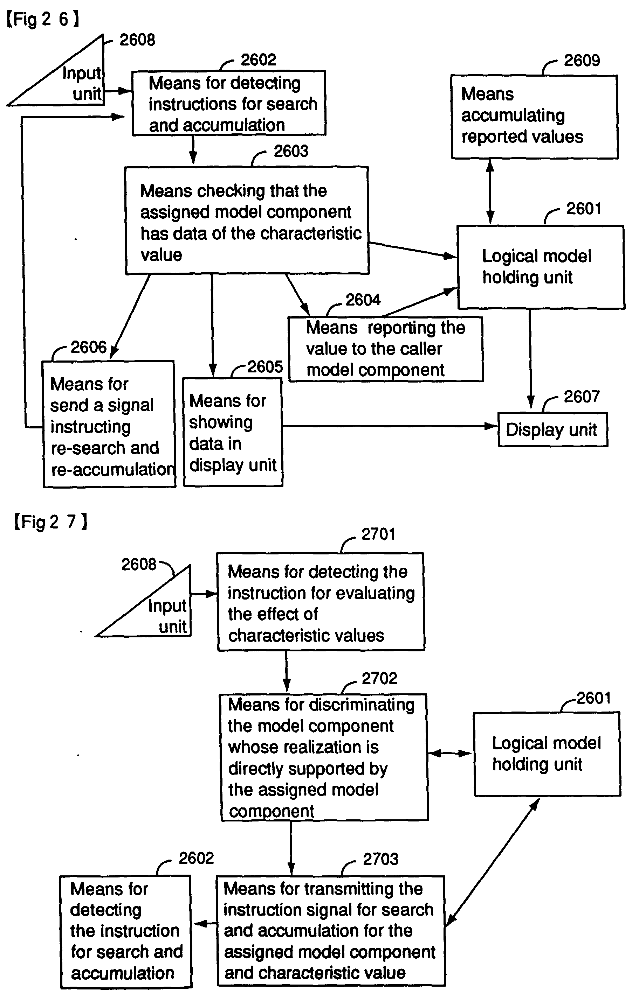

Given model components X and Y, an example of a "reference" in the present invention is illustrated. If the apparatus storing the logical model is a computer, an example reference is the main memory address (a "pointer") of Y. This is illustrated in FIG. 2. Address 202 of Model Component Y 203 is set inside Model Component X 201. If the program is written in C, it is easy to access the memory by memory address. The relationship (or connection) in an object-oriented database is also a "reference."

As illustrated in FIG. 3, there is also the case where the name "Name-Y" is given to Model Component Y 301. If Model Component X 302 has stored "Name-Y" as a reference, the system has only to consecutively check prospective model components and find the name "Name-Y". If this "procedure to find" is defined, the condition of a reference by the present invention is fulfilled. As can be seen in FIG.3, candidate models are in a simple list. But various kinds of methods, such as the hashed array or the binary tree, can be used to represent such a collection. Any name, including marks and symbols, can be used to discriminate model components.

FIG. 4 illustrates a reference when there are plural listings. Data to discriminate the list is added to the name of the model component as reference. "List A : Name-Y" is set as a reference in Model Component X 401, as shown in FIG. 4, and the model component of Name-Y (i.e., Model Component Y 403) is found from List A 402. If the procedure to access to the model component is defined by data specifying the list and the name of the model component, the condition for a reference by the present invention is fulfilled.

FIG 5 illustrates an example using an access table. To assign Model Component Y 502 as an access destination from Model Component X 501, the name of Model Component X (i.e., Name-X) is entered into the Access Table 503 as a (one of) reference starting point. And the relevant access destination Model Component Y (Name-Y) is entered into Access Table 503. This is the process to set references. The procedure to find the access destination from Model Component X 501 is to refer to Access Table 503. Then to determine Name-Y, the data of relevant access destination from Name-X, and to get Model Component Y 502 as the access destination. If this procedure is defined, the condition of a reference by the present invention is fulfilled.

FIG 6 illustrates the case where model components are distributed among plural apparatus. Here, Model Component X 604 is in Apparatus P 601, and the reference destination is Name-Y. By referring to the corresponding table for model components 605 in Apparatus Q 602, model component Name-Y is found to be in Apparatus R. The system then traces the list in Apparatus R via Connection Circuit 607, and gains access to Model Component Y 606. This system will work provided that the each apparatus has stored in advance information that the Table for Model Component 605 is in Apparatus Q. If the procedure detecting the apparatus in this way, and accessing the model component therein is defined, the condition for a reference by the present invention is fulfilled.

Information of references can be entered not only into a model component, but also into other model components of a reference destination from the given model component by reference, or a mere memory. In FIG.7, Name-Z has been assigned in Model Component X 701 and Name-Y has been assigned in Memory Block 702, labeled Name-Z. If the procedure to trace Name-Z and Name-Y in turn and to access to Model Component Y is defined as the procedure starting form Model Component X 701 and determining the relevant access destination, the condition for a reference by the present invention is fulfilled. Memory Block 702, whose label is Name-Z, can either be a model component or mere memory. For example, Memory Block 702 can be the dedicated entirely as a memory block for storing a reference.

### 〈〈Section 8.3: The Meaning of References〉〉

When a reference from Model Component X to Model Component Y is set, that reference can have several meanings. One meaning is the "relationship that supports realization". If circuits connecting node model components of Communications Network A are to be provided from Communications Network B, reference is set from a service model component of a service sub model of Communications Network B to the link model component connecting the relevant node model component of Communications Network A. This is an example of a realization-supporting relationship. The reference for the relationship that supports realization is set in the model component inside Communications Network B to this service model component. The converse relationship is the "relationship in which realization is supported".

The "relationship that supports realization" from service model components representing transportation (such as transportation by plane or truck) is set to link model components connecting transportation points in a transportation plan.

In human or organizational interrelationship diagrams, the "relationship that supports the realization" reference is set from the service model components representing concrete relationship of persons or organizations, to the link model components of the relationship of persons or organizations.

In addition, there is the "adjacent relationship" which represents the connecting relationship between node model components and link model components. If there are many kinds of references, they can be discriminated by attached labels. If a reference is a pointer, the pointer and the label together are recognized as a reference. If the program is written in C, this can be implemented as the structure. By labeling references, a system can trace specific references. The system can trace model components that support realization of a service model component and reach model components of the other logical models. In procedures such as deleting model components, searching characteristic values and evaluating the effect of changing characteristic values, the system discriminates the kind of the relationship between model components and finds the right reference.

Even without attaching a label to a reference, in seeing what kind of model components there are connected by reference or just by the data that the model components store, the relationship can be determined. For example, the reference between a communications link model and the node models at each end can be determined to be an "adjacent relationship".

### 〈〈Section 8.4: References of Logical Models〉〉

In this description, the "reference between Model Component X and Logical Model Z" means the "reference between (any) model component of Logical Model Z and Model Component X". If Model Component X is the model component of Logical Model Z, "reference between Model Component X and Logical Model Z" means the reference between the model component of Logical Model Z except for X and Model Component X.

### 〈〈Section 9: Division of the Procedure for Generating Models〉〉

### 〈〈Section 9.1: Division of the Procedure for Generating Models〉〉

Section 4 introduced the "service sub model" and the "actual sub model" for designing accurate logical models related each other. This section describes the "core model component" to help design logical models more efficiently. It is necessary to represent the relationship(s) between logical models before generating the concrete contents of the logical models.

Before generating a concrete logical model, the service request-provision relationship can be represented by the "relationship that requests the service" and the "relationship that provides the service" among core model components set for each logical model to be generated. This is illustrated in Step 1 of Section 11 (FIG. 18).

### 〈〈Section 9.2: Provision Service Data〉〉

When one logical model is designed, other logical models provide only the service model components requested. Data that defines specifications of service model components being provided is "provision service data".

In design models of communications networks, the basic scheme of communication (such as ATM, X25, ISDN Service B Channel and Frame Relay), circuit speed, Committed Information Rate (CIR) of Frame Relay, the cost, guaranteed quality, the actual value of the quality and the like are specified. In transportation plans, the flight number, freight class, price, cargo capacity class of vehicle, maximum speed, transportable weight and capacity by one transportation, estimated transportation time, et cetera, are specified as provision service data.

When a service model component is requested from another logical model, the appropriate service model component is provided according to the provision service data. The word "appropriate" here is to provide the service model component with the relevant speed to satisfy the circuit request of a certain speed. It is possible to provide a service that meets the request, when there is a service value exceed the requested speed or CIR,

Provision service data can be set in a core model component. In this case, the service that this model component provides is assigned here in the said core model component. If the contents of the provided service are changed in each communication section, provision service data is set in respective link model components.

It is possible to generate a model component dedicated for recording provision service data, and to make it a constituent element of a service sub model. If this dedicated model component is referred from a core model component or a link model component, these core model components or link model components can share the said model component.

### 〈〈Section 9.3: Background dedication models〉〉

The provided service model component is accommodated in a service sub model. At a processing step to generate this model concretely, the system generates the structure of the actual sub model necessary to realize these sub model components. However, some models do not have to generate actual sub models. For example, in a plan to travel around the world by air, flight data is needed (as a service model component), but planning the actual routes and scheduling of the flight is unnecessary. This kind of model is called a "model only for background use".

There have been examples in the past (and still exist) that seemingly handle a plurality of logical models, but there is actually only one logical model of subject, and the others are mostly just models only for background use. As all the model components in this case were constituent elements of a single model, it was possible to generate the model regardless of the present invention.

### 〈〈Section 9.4: Management of Service Model Components〉〉

Service sub models are convenient for managing service model components. As an example, assume that Communications Network A provides two 64 kbps circuits for Communications Network B and three 64 kbps circuits for Communications Network C, as connecting circuits of Tokyo and Osaka. This case can be modeled with service model components representing two 64 kbps and three 64 kbps circuits that are connected by reference to the communication link model component between Node Model Component Tokyo and Node Model Component Osaka. Furthermore, references are set between respective communications service model components and Communications Network B and Communications Network C. By tracing references from link model component of service sub model, list of service model components provided for each area can be achieved.

It is possible to register in advance sites as node model components that can provide service model components and to provide service only for combination of these sites. It is also possible to register in advance link model components that can provide service model components for the relevant communication sections.

### 〈〈Section 10: The procedure to Generate Logical Models〉〉

If the procedure to generate logical models is roughly divided, it can be divided into two phases: One which provides service model components and generates service sub models, and one which generates the structure of actual sub models to realize these service model components. The contents are described in detail below.

FIG 8 illustrates the structure of the program generating logical models. It is implemented as an "event driven program" to launch a process relevant to a received instructions through the input unit. There are also cases where a process rises events to launch other processes. The "reception process for procedure launching events" 801 invoke the relevant process. Programs necessary to generate logical models, that are to embody actual sub models, can be classified into three groups. That are the "group of processes associated with basic definitions of a logical models" 802, the "process for providing a service model component" 803, and the "group of processes for generating an actual sub model 804". In addition to these three, there is the "process setting service model components a priori" 805, which makes a trigger data to start the initial step for generating logical models. Each process is described in the following.

### 〈〈Section 10.1: Group of processes associated with basic definitions of logical models〉〉

FIG. 9 illustrates the details of the "group of processes associated with basic definitions of logical models" 802 in FIG. 8. When the system thereof assigns a name to a logical model and launches the "logical model registration process 901", the system "generate core model component" 902 and "assign the name to core model component" 903.

In the "provision service data assignment process" 904, the system first "receives provision service data" 905 from external or internal data of the system and "sets provision service data in the core model component" 906. If the dedicated model component of the provision service data is used, the system generates the model component and records the received provision service data in it. Next, the system sets the reference from the core model component to the model component of the provision service data.

Following that, the "service provision location and area assignment process" 912 is launched. If locations and areas for which the service can be provided are not assigned (assuming that the service can be provided to any location or area), the system is not executed in this point in time. In assigning the location and the area for which the service can be provided, the system generates the service sub model and sets the reference from the core model component. If external or internal data of the system assigns service-provisioning sites without relevant node model components, new node model components are generated. Communication sections that can provide services should be specified externally. If the relevant link model component for this assignment cannot be found, a new link model component is generated. If there are no node model components at either ends of the link model component in the service sub model, new node model components are also generated.

In the "process to assign request-provision relationships of service model components" 910, the system sets the relationship expressing the request and the provision of service. That is, the system "sets the reference from the request side core model component to the provider side core model component" 911. In general, if all service model components necessary for the actual sub model of Logical Model A are provided by Logical Model B, all the operator has to do is set the relationship of the core model components by reference in this manner. However if the service is provided for the (discriminated) Link Model Component X of Logical Model A by Logical Model C, the reference from Link Model Component X to Core Model Component C should be set.

### 〈〈Section 10.2: Process for Providing a Service Model Component〉〉

The "process for providing a service model component" 803 in FIG. 8 that provides service model components according to the requests from other logical models. This detail is illustrated in FIG. 10. In FIG. 10, the system executes the "judgment on capability to provide service model component" 1001. FIG. 11 illustrates the detailed process to "judge on capability to provide service model component" 1001 when service provision locations and areas are assigned.

The system first executes the "determining whether service provision nodes are assigned in the provider side service sub model" 1101, as in FIG. 11. If service provision nodes are assigned, the system proceeds to "determining whether the relevant node model components for the requested service exist in the service sub model" 1102. The phrase "relevant node model components" used here means node model components for the points linked by the requested service. If service provision nodes are assigned but there aren't any relevant node model components as is mentioned above, the system "decides that the service cannot be provided" 1106. In other cases, the system proceeds to determine communication section that can provide service.

The system "determines whether service provision sections are assigned in the provider side logical model" 1103. If the said service provision sections are assigned, the system "determines whether the relevant link model component for the requested service exists in the respective service sub model" 1104. Here, "relevant link model components" are the link model components connecting the relevant node model components for the points linked by the requested service. If service provision section are assigned but there aren't any relevant link model components, the system "decides that the service cannot be provided" 1106. In other cases, the system "decides that the service can be provided" 1105.

Even if the system determines that the service can be provided (in the "judgment on capability to provide service model components" 1001 process, shown in FIG. 10), there are some cases where the system determines that that service cannot be provided in a later process shown in FIG. 10. If the system determines that the service cannot be provided in the "judgment on capability to provide service model components" 1001 process, the procedure of FIG. 10 completes.

As a result, the effectiveness of using service sub models to judging on capability to provide service model components are as follows:
(1) Realization of a comprehensive (operator friendly) user interface, which assigns service provision locations and areas. In other words, the system shows the service sub model to the window and operators selects nodes and links by this window.
(2) Consistency with the method to use service sub models and manage provided service model components (Section 9.4).
   The method for this determination is consistent to the method for managing the provided service model components by the relevant service sub models. (Section 9.4).
(3) The system can judge the capability to provide service model components only by checking the existence of relevant links.

If the system determines that the service can be provided in the "judgment on capability to provide service model components 1001" process, the processes below are executed. The system "generates a service model component according to the provision service data" 1003, and accommodates the generated service model component in the service sub model. If the system fails to generate the given service model component, the system informs the result to the service request side and exits the process. If the system succeeds in generating the said service model component, the system "writes the characteristic values to the generated service model component" 1004. The term "characteristic values" means the data of service values (such as circuit speed and flight number), the price, et cetera, as well as the values of various other qualities. Next, the system "sets references between the service provider side logical model and the service model component in both directions" 1005. As described in Section 8.4, this operation means setting a reference in both directions between any model component of the service provider side logical model and the said service model component.

Finally, the system "reports the service model component to the service request side" 1006 and exits the process. On the service request side, the "relationship that supports the realization" and the "relationship by which the implementation is supported" are set between the service model component and the model component using the said service model component.

There are a number of examples for the process of "setting the references between the service provider side logical model and the service model component in both directions" 1005. When not using any service sub model, a reference in both directions is set between the core model component and the generated service model component. When using a service sub model, a reference in both directions are set between the generated service model component and the relevant link model component for the service sub component.

FIG. 12 describes another example of the "judgment on capability to provide service model components" 1001 process, where a service model component can be provided for any locations and areas. First, the system "determines whether the relevant node model components for source and sink of the service model component to be provided exist in the service sub model" 1201. If a relevant node model component is not found, the system then "generates the relevant node model components in the service sub model" 1202. The phrase "relevant node model components" here means the relevant node model component for the points connected by the requested service. Next, the system "determines whether the relevant link model component for the service model component to be provided exists in the service sub model" 1203. If the relevant link model component is not found, the system "generates the relevant link model component in the service sub model" 1204. The term "relevant link model component" means the link model component connecting to the relevant node model components corresponding to points connected by the requested service. Finally, the system "sets the reference from the relevant link model component in the service sub model to the service model component to be provided" 1205.

### 〈〈Section 10.3: Group of Processes for Generating an Actual Sub Model〉〉

FIG. 13 illustrates the actual process of the "group of processes for generating an actual sub model 804" in FIG.8. Details differ according to what the logical model represents, but a typical procedure for designing a communications networks is given in FIG. 13, which can also be applied to generating transportation plans.

Typical processes from the group of processes for generating an actual sub model are "topology determination process" 1301, "flow assignment process" 1302, "service capacity assignment process" 1303, and "apparatus capacity assignment process" 1304. The system invokes the "process to generate the service model component representing detouring traffics" 1305, when the system makes a logical model prepared for detour in cases of failures. These failures are failures of communication equipment and circuits of communications networks, closing down of airports and problems with airplanes, the death of an important person who played a connecting role between companies, and so on. Other processes for generating logical models can be added, but they have been omitted in FIG. 13.

### 〈〈Section 10.3.1: The Topology Determination Process〉〉

There are various procedures for determining topology. FIG. 14 illustrates the process for determining a basic two-level hierarchical network topology is as an embodiment of "topology determination process" 1301. First, the system "selects higher-level node model components from node model components of an actual sub model" 1401. It is also possible to add higher level nodes to the actual sub model in advance. Next, the system "sets link model components connecting among higher level node model components" 1402. Finally, the system "sets link model components between higher-level node model components and lower-level node model components" 1403. Thus through the fundamental circuit of a two-level hierarchical network, the basic topology can be determined.

### 〈〈Section 10.3.2: The Flow Assignment Process〉〉

In the "flow assignment process" 1302, the system set references connecting service model component to be provided, link and node model components that support the realization of the said service model component. A path model component can be inserted among them. The "path model component" is the model component in which a reference is set (or is planned to be set) to/form node model components and link model component constituting the path, and representing them as constituent elements of the path.

In this case, the system connects the service model component and the path model component that supports the realization of the said service model component by a reference. It also then connects the path model component, the link model component, and the node model component that support the realization of the said path model component by a reference. These references are set in both directions for the convenience in handling deletions, searches, and alterations of characteristic values.

FIG. 15 illustrates the embodiment of the "flow assignment process" 1302 without using the path model component. The system "retrieves service model components to be provided sequentially" 1501, and then "sets references between the service model component and the relevant node and link model components" 1502.

### 〈〈Section 10.3.3: The Service Capacity Assignment Process〉〉

In the "service capacity assignment process" 1303, the system requests service model component to another model components in order to realize (provider side) service model component supporting realization of a link model component of an actual sub model. If the case of communications networks, circuits and the like, which realize the links, are the above service model components (requested to other model components).

The request destination is the logical model assigned in the "process to assign request-provision relationships of the service model component" 910. It is possible to assign logical model to link model component. Service model components of this link are requested to this logical model. By combining this assignment with the assignment in the "process to assign request-provision relationship of the service model component" 910, further complicated assignments can be undertaken. If the link model component is not given any assignment, the system uses the assignment indicated by the "process to assign request-provision relationship of the service model component" 910. And with any given assignment in the link model component, the system uses this assignment thereof and requests the relevant service model component(s).

There are many variations in the procedure for assigning service capacity. As one embodiment, the system requests and accepts service model component that covers all provider side service model components assigned to links (that is higher speed circuit in case of communications networks). This is illustrated in FIG. 16. First, the system "retrieves link model components" 1601 of an actual sub model, and "accumulates the characteristic value of service model components (such as circuit speed) whose realization is supported by the said link" 1602. Then the system "requests service model component whose characteristic value is the accumulated value" 1603. If the service model component that has the sufficient characteristic value for the request is provided, the system "sets a reference in the both directions between the provided service model component and link model component" 1604.

### 〈〈Section 10.3.4: Detouring and Overflowing〉〉

To treat sharing loads and/or detouring in case of possible faults, the system generates a new service model component to represent overflowing or detouring traffic.

The term "overflowing" reflects a situation where overflowing parts are assigned to other model components because the original (in this situation) model components such as links and nodes cannot carry any or all the parts.

If the characteristic value of the service model component provided in "requesting service model component whose characteristic value is the accumulated value" 1603 in FIG. 16 is insufficient for the request, the system "generates a service model component representing traffic overflow" 1605. And the system connects newly generated service model components with the link model component or the path model component that was planned to carry the said service model components by a reference. Since the initial service model component is divided due to the overflow, the original service model component and the divided service model components should be connected by a reference. In this way, even if the original service model component is deleted, its effect can be evaluated accurately. As a new service model component carrying the overflow is added, the "service capacity assignment process" for the link model component of the actual sub model is repeated again.

The term "detouring" means changing the model component that supports the realization of a service model component, due to failures or congestion of model components. Assuming failures, we can simulate detouring.

In the "process to generate the service model component representing detouring traffic" 1305 in FIG. 13, the system assumes potential faults, et cetera, and searches the detouring traffic to be treated, and generates the service model component representing these cases. In detouring, the path that the service passes through under ordinary circumstances (that is, exactly the "path model component that supports the realization of the service model component"), and the path taken at extraordinary times are different. In addition to the service model component passing through the path during ordinary times, the system generates the service model component passing through the path during extraordinary times and connects it with the original path model component by a reference. By tracing references, the system can delete or change the relevant model component. For example, if the original service model component (during ordinary times) is deleted, the service model component of detouring traffic is also deleted.

If the system connects the detouring or overflowing service model components, the link or node model components, and the path model component that caused the detouring or overflowing by references, the system can delete the detouring or overflowing service model component when the problem has ceased.

By attaching detouring or overflowing labels to the service model component, the system utilizes these labels in the service capacity assignment process. For example, the system can control how much the volume of detoured service model component should be considered in the service capacity assignment process. The system can ignore all detoured service model components (in other words, examine only non-detouring service model component at ordinary times) and then assign capacity usage. The system also can add capacity sufficient to carry all detouring service model components (caused by one fault). With a detouring label, the system can apply management not to detour the detoured service model component again.

Other kind of labels of the service model component can be added, besides the detouring and overflowing labels. From these label data, the system reroutes the service model component for monitoring and controlling at maximum degree. These new label data are called "purpose or cause indicators".

### 〈〈Section 10.3.5: The Apparatus Capacity Assignment Process〉〉

In the "apparatus capacity assignment process", the system fixes the type and number of equipment necessary to realize the provider side service model component assigned to the node model component. Operator assigns the type (or types) of equipment to be selected and set these data to the core model component. Or operator can set a reference between the core model component and the model component representing the type of equipment. The system can also assign the type of equipment to the node model component. The system selects from these types of equipment that realizes the provider side service model component.

FIG. 17 illustrates an example of apparatus capacity assignment process, that selects equipment realizes the provider side service model components. The system "retrieves node model components sequentially" 1701, and "accumulates characteristic values of service model components whose realization are supported by the node" 1702. This characteristic value is, for instance, a circuit speed. The system "generates an apparatus model component that can provide the accumulated characteristic value 1703", and if the system can generate the said apparatus model component, the system "sets references in both directions between the generated apparatus model components and the node model component" 1704.

### 〈〈Section 10.4: Process setting service model components a priori〉〉

It is the "process setting service model components a priori" 805, that accepts the first direction of communication service model components (by operator). When the operator from the external of the system or other internal process request service, the system sets the service model component in the service sub model of assigned logical model in the "process setting service model components a priori" 805.

Following that, the process for generating an actual sub model is launched for each logical model. As one actual sub model is generated, service model components are generated in service sub models of other logical models. Thus processes for generating actual sub model will be invoked consecutively. These series of processes are completed when all actual sub models are developed except for logical models for background use (Section 9.3).

### 〈〈Section 11: The First Embodiment for Generating Logical Models〉〉

FIG. 18 illustrates the embodiment for generating logical models. The system assigns Name A and launches the "logical model registration process" 901 and generates Core Model Component C (A) 1801 with Name A. In the same way, the system assigns Name B and generates Core Model Component C (B) with Name B 1802.

In the "process to assign request-provision relationship of the service model component" 910, the system sets the reference from Core Model Component C (A) with Name A 1801 to Core Model Component C(A) with Name B. The said reference shows the "service request relationship". The above process is the first step for generating logical models.

In the second step, the system launches the "process setting service model components a priori" 805 and assigns the service model component connecting Location A1 with Location A2. At this point, the system first generates Node Model Component N (A1) 1803 with Name A1 and Node Model Component N (A2) 1804 with Name A2 and Link Model Component L(A3) 1805 with Name A3 to connect with the said two core model components. The system sets the references meaning "managing/managed relationship" between Core Model Component C(A) 1801 of Name A and the above model components. The system sets reference showing the adjacent relation between Node Model Component N (A1) 1803 with Name A1 and Link Model Component L (A3) 1805 with Name A3 in both directions. The system also sets the reference showing the adjacent relation between Node Model Component N (A2) 1804 with Name A2 and Link Model Component L (A3) 1805 with Name A3 in both directions.

When the service model component for this link is requested from internal or external processes of the system, the system assigns C(B) 1802, Core Model Component with Name B, and launches the "process for providing a service model component" 803 (detail is illustrated in FIG. 10).

The system then generates Service Model Component S (B0) 1806 with Name B0. The system sets the reference showing "managing/managed relationship" between Core Model Component C(B) 1802 with Name B and Communication Service Model Component S(B0) 1806 with Name B0. The reference showing "realization supporting /supported relationship" (or "service requesting/provisioning" relationship) is set between Link Model Component L (A3) 1805 with Name A3 and Service Model Component S (B0) 1806 with Name B0 in both directions. At this point, an extensive reference from Service Model Component S (B0) 1806 with Name B0 to Link Model Component L (A3) 1805 with Name A3 shows the relationship "supporting the realization" or "the service provision". The converse extensive reference shows the relationship of the "realization is supported" or the "service request".

In the third step, the system launches the group of processes for generating actual sub model of Logical Model B. As a result of the "topology determination process" 1301 and the "flow assignment process" 1302, the system sets references in both directions showing "realization supporting/ supported relationship" among Service Model Component S (B0) 1806 with Name B0, Node Model Component N (B1) 1808 with Name B1, Node Model Component N (B2) 1809 with Name B2, and Link Model Component L (B3) 1810 with Name B3.

The system retrieves the service model component that supports the realization of Link Model Component L (B3) 1810 with Name B3, and launches the "service capacity assignment process" 1303 in order to make connections among them by references. In the said process, the system "requests service model component whose characteristic value is the accumulated value" 1603, and launches the provider side "process for providing a service model component" 803 (details illustrated in FIG.10), and "sets references in both directions between the provided service model component and the link model component" 1604.

### 〈〈Section 12: The Second Embodiment for Generating Logical Models〉〉

FIG. 19 illustrates another example for generating logical models. Logical Model A is composed of the service sub model and the actual sub model. The extensive reference showing "managing/managed relationship" is set between Service Model Component S (S0) 1904 with Name S0 provided by the logical model's service sub model and Link Model Component L (S3) 1903 with Name S3. Furthermore, the relationships showing adjacent relations between Link Model Component L (S3) 1903 with Name S3 and Node Model Components N (S1) 1901 with Name S1 and Node Link Model N (S2) 1902 with Name S2 are each set in both directions.

When the system launches the group of processes for generating actual sub model of Logical Model A, the "topology determination process" 1301 and then the "flow assignment process" 1302 are sequentially launched. As a the result of these processes, references are each set in both directions between Service Model Component S (S0) 1904 with Name S0 and the model component that supports the realization, that is Path Model Component P (R0) 1905 with Name R0. And references are set in both direction between Path Model Component P(R0) 1905 with Name R0 and model components that supports the realization, that are Node Model Component N(R1) 1906 with Name R1, Node Model Component N(R2) 1908 with Name R2, Node Model Component N(R3) 1910 with Name R3, Link Model Component L(R4) 1907 with Name R4, and Link Model Component L(R5) 1909 with Name R5.

When the system assigns Link Model Components L(R4) 1907 with Name R4 and launches the "service capacity assignment process" 1303, the reference for "realization supporting/supported relationship" is set between the said Link Model Component L and Service Model Component S (RS0) 1912 with Name RS0 provided by another logical model (Logical Model B). Similarly, the reference for "realization supporting/supported relationship" is set between Link Model Component L (R5) 1909 with Name R5 and Service Model Component S (RS1) 1914 with Name RS1.

The system assigns Node Model Component N(R1) 1906 with Name R1 and launches the "apparatus capacity assignment process" 1304. As a result, Apparatus Model Components E(RE0) 1911 with Name RE0 is generated and the reference for "realization supporting/supported relationship" is set. Again in the same way, the reference for "realization supporting/supported relationship" is set between Node Model Component N (R2) 1908 with Name R2 and Apparatus Model Component E (RE1) 1913 with Name RE1. Then the reference for "realization supporting/supported relationship" is set between Node Model Component N (R3) 1910 with Name R3 and Apparatus Model Component E (RE2) 1915 with Name RE2.

### 〈〈Section 13: Process to Delete Model Components〉〉

The "process to delete model components" 806 in FIG.8 is used to realize the method for deleting the model component as a part of the event-driven program. FIG. 20 illustrates the detailed process assigning the model component to be deleted and launching the "process to delete model components" 806. The system first "sets deletion candidate label to model component assigned" 2001. The system applies the process for "retrieving model components associated, by reference, with the model component of the deletion candidate" 2002. If the said model component is retrieved, the system "determines whether it is a candidate of the adjunct deletion" 2003.

For example, if the node is the deletion candidate, the adjacent link model components are candidates for adjunct deletion. If the link model component is the deletion candidate, the service model component whose realization is supported by the said link model component is the candidate for adjunct deletion. Upon deciding for adjunct deletion, the system "sets the deletion candidate label to the model component to be deleted" 2004.

Again, if the deletion candidate label is attached to the node model component, deletion candidate labels are also attached to the adjacent link model components. If the deletion candidate label is attached to the link, the deletion candidate label is also attached to the service model component "whose realization is supported" by the link.

Covering model components where new deletion candidate labels are set, the system "retrieves model components associated, by reference, with the model component of the deletion candidate" 2002 and "determines whether it is a candidate for the adjunct deletion" 2003. The system traces relations in this way and sets deletion candidate labels successively.

When all determinations have been made, the system "determines whether the model component of the deletion candidate can be deleted" 2005. One of these embodiments shows all model deletion candidate components on Display Unit 12, to receive the operator's approval for executing the deletion. There is another way to determine deletion by checking the deletion approval specifications given in advance. Finally, the system "simply deletes model components where the deletion candidate labels are attached" 2006.

### 〈〈Section 14: Process for Searching and Accumulating Characteristic Values〉〉

When the system (assigns and) inquires characteristic value to the model component and the said characteristic value is found in the given model component, that value itself is the answer. "Guaranteed bit error rate" given to Service Model Component X is an answer where the "guaranteed bit error rate" of Service Model Component X is necessary. However if the said characteristic value is not given to Model Component X, the system searches and recursively retrieves whether or not the "guaranteed bit error rate" is given in the model component that supports the realization of Service Model Component X. The system also accumulates them of retrieved Model Components to acquire the "guaranteed bit error rate" of Service Model Component X.

An example of realizing the process for searching and accumulating characteristic values as an event-driven program is the "process for searching and accumulating characteristic values" 807 in FIG. 8. In the "process for searching and accumulating characteristic values" 807, the system recursively launches the "process for searching and accumulating unit", illustrated in FIG.21. In other words, when the system assigns the model component and (type of) characteristic values to be searched and launches the "process for searching and accumulating characteristic values" 807, the "unit process for searching and accumulating" in FIG.21 is immediately launched. In process 807, the system initially "determines whether data of the assigned characteristic value are set in this model component" 2101. If there is the said characteristic value, the system "reports the data as the characteristic value to the caller model component" 2105, and exits the process.

If there isn't the said characteristic value, the system "sequentially selects model components that supports the realization of this model components" 2102, and "launches the unit process for searching and accumulating (FIG. 21), assigning the selected model component" 2103. In other words, the "unit process for searching and accumulating" illustrated in FIG. 21 is recursively launched. Then the system "accumulates the reported values in the way assigned to each kind of characteristic value" 2104.

For example, if the characteristic value is "bit error rate", and the reported "bit error rates" of the communication model components in serial order, (approximation of) accumulated value can be calculated by the sum of each "bit error rates". Similarly, the way to accumulate the value (adding, multiplying, selecting minimum or maximum, specified function) is specified in advance for combination of a kind of characteristic value and arrangements of model component (i.e. series, parallel). Finally, the system "reports the accumulated reported values as a characteristic value" 2106.

We can select model components to which the characteristic value is set in advance, considering the definition of the characteristic value and the how the value is to going to be used. A mark to stop recursive searching is set in order to avoid an endless search because of no characteristic value assigned. For cases the model component that supports the realization is exhausted without finding characteristic value, we can define default value (such as zero) to be reported.

### 〈〈Section 15: Process for Evaluating the Effect of Changing Characteristic Value〉〉

When a new characteristic value is set in the model component or when the characteristic value of the model component is changed, it is very useful to see how the effect thereby spreads to any given model component of any given logical model. It can be an effective method in managing and improving quality if the operator can evaluate the effect of changing "guaranteed bit error rate" of a service model component.

It is the "process for evaluating the effect of characteristic values" 808 in FIG.8 which realizes the process for evaluating the effect of changing characteristic values as a part of an event-driven program. The "process for evaluating the effect of characteristic values" 808 recursively launches the "the first unit process for evaluating the changing characteristic value" illustrated in FIG.22, and the "second unit process for evaluating the effect of characteristic value" illustrated in FIG.23. First the system assigns the model component and the characteristic value of the object for evaluating the effect of the change. To launch the "process for evaluating the effect of characteristic values" 808 is to launch directly the "the first unit process for evaluating the effect of characteristic value" illustrated in FIG. 22. Then the system "finds a model component whose realization is supported by the assigned model component" 2201, and "launches the second unit process for evaluating the effect of characteristic values for the assigned model component and the assigned characteristic value" 2202.

The "second unit process for evaluating the effect of changing characteristic value" in FIG. 23 first "determines whether data of the assigned characteristic value is set in this model component 2301. If there is the data, the process uses it, because it is a priori assigned externally. Then the system completes the process. This process can also change the pre-assigned data during the process for evaluating the effect of changing the characteristic value, but the detailed explanation has been omitted.

If data of the assigned characteristic value is not set, the system "launches the unit process for searching and accumulating for this model component (FIG.21) and the assigned characteristic value" 2302. Then the system "shows the accumulated characteristic value and the corresponding model component to the display unit 12" 2303. In other words, the system shows the evaluation results of the effect of changing characteristic values before the operator.

The "unit process for searching and accumulating" launched in the above procedure is the process to realize the "process for searching and accumulating characteristic values" 807, and is described in Section 14 (FIG.21). That is to say, the system accumulates characteristic values as the characteristic value for the model component assigned at the invoking phase of the second unit process for evaluating the effect of characteristic values, through the "process for searching and accumulating characteristic values" 807. The system then "launches the first unit process for evaluating the effect of characteristic values" 2304. The process for evaluating the effect characteristic values is realized by recursively launching the first and second unit processes to evaluate the effect of characteristic values.

### 〈〈Section 16: The Apparatus for Generating Logical Models〉〉

The apparatus for generating logical models is illustrated in FIG. 24. The system analyzes the signal from "input unit" 2418 in the "signal reception means 2401, and sends the launching signal to the relevant means. There are also some cases where another signal is sent from these means to the "signal reception means" 2401. When the means for generating logical models are launched, the structure of logical models stored in the logical model storing unit 2402 changes. This changing situation is shown in "display unit" 2419. The apparatus for generating logical models has many means for achieving its goal(s), but for brevity, only the means to set references between model components, which are constituent elements, of a logical model are illustrated in FIG. 24.

### 〈〈Section 16.1: The First Operational Example〉〉

Receiving a signal to "means for setting references in both directions between service model component and link model component of service sub model" 2403, the system sets references in both directions between model components in the holding unit for logical models 2402. They are the assigned service model component 2412 and the link model component 2411.

Receiving a signal to the "means for setting references in both directions between service model component and link model component that supports the realization of the said service model component" 2407, the system sets references in both directions between model components in the holding unit for logical models 2402. They are the assigned service model component 2412 and the path model component 2413.

Receiving a signal to the "means for setting references in both directions between path model component and link model component that supports the realization of the said path model component" 2404, the system sets references in both directions between model components in the holding unit for logical model 2402. They are the assigned path model component 2413 and link model component 2416.

Receiving a signal to the "means for setting reference in both directions between link model component and service model component that supports the realization of the said link model component" 2406, the system sets references in both directions between model components in the holding unit for logical model 2402. They are the assigned link model component 2416 and the service model component 2417.

As can be seen in the given examples, service model components and the relevant service model components that support their realization are connected by a series of references.

### 〈〈Section 16.2: The Second Operational Example〉〉

Treating node model components and apparatus model components, the system receives additional signals. One signal is to the "means for setting references in both directions between path model component and node model component that supports the realization of the said path model component" 2408. Another signal is to the "means for setting reference in both directions between node model component and apparatus model component that supports the realization of the said node model component" 2410.

Receiving a signal to the "means for setting references in both directions between path model component and node model component that supports the realization of the said path model component" 2408, the system sets references in both directions between model components in the holding unit 2402 for logical models. They are the assigned path model component 2413 and the node model component 2414.

Receiving a signal to the "means for setting reference in both directions between node model component and apparatus model component that supports the realization of the said node model component" 2410, the reference is set in both directions among model components in the logical model holding unit 2402 for logical models. They are the assigned node model component 2414 and the apparatus model component 2415.

### 〈〈Section 16.3: The Third Operational Example〉〉

If a path model component is not used, the system uses two means. One is the "means for setting reference in both directions between service model component and link model component that supports the realization of the said service model component" 2405. Another is the "means for setting references in both directions between service model component and node model component that supports the realization of the said service model component" 2409.

Receiving a signal to the "means for setting reference in both directions between the service model component and link model component that supports the realization of the said service model component" 2405, the reference is set in both directions between model components in the holding unit 2402 for logical models. They are the assigned service model component 2412 and the link model component 2416.

Receiving a signal to the "means for setting reference in both directions between service model component and node model component that supports the realization of the said service model component" 2409, the system sets reference in both directions between model components in the holding unit 2402 for logical models. They are the assigned service model component 2412 and the node model component 2414.

### 〈〈Section 16.4: The Fourth Operational Example〉〉

If a service sub model is not used, the system uses the "means for setting references from the provider side core model component to the service model component". This is a substitution of the "means for setting the references in both directions between service model component and link model component of the service sub model" 2403.

### 〈〈Section 16.5: The Fifth Operational Example〉〉

If the system generates a logical model to handle detouring and overflow traffic, the system uses the following means. That are the "means for generating a new service model component representing traffic caused by detouring and overflowing" 2420. The system generates a new relevant service model component to be stored in the holding unit for logical models 2402.

### 〈〈Section 17: The Model Component Deletion Apparatus〉〉

FIG. 25 illustrates the structure of the apparatus for deleting model components. Logical models and model components are stored in the "logical model storing unit" 2501, and are shown in "display unit" 2507.

Signals from the "input unit" 2508 are analyzed by the `means for detecting the deletion instruction" 2502. If the instructions for deleting model component are detected, signal is sent to the "means for setting deletion candidate labels to model components assigned as deletion candidates" 2503, and the deletion candidate label is attached to the assigned model component. And signal is sent to the "means for determining whether or not the model component is an adjunct deletion candidate from deletion candidate labels of model components connected with the deletion candidates" 2504. The system detects the target model component and decides that it is a candidate of adjunct deletion or not.

This decision will be made by the deletion candidate labels of logical models connected to the target logical models. Section 13 described details of this procedure.

If there are any model components of adjunct deletion, the system send a signal to the "means for setting a deletion candidate label" 2505, and the deletion candidate label is attached to the model component. Attaching a new deletion candidate label to the model component, the system receives a signal from the "logical model storing unit" 2501. And the system pass this signal to the "means for determining whether or not the model component is an adjunct deletion candidate from deletion candidate labels of model components connected with the deletion candidates" 2504. And the system determines adjunct candidates.

Completing adjunct candidates judgment, the system launches the "means for acceptability check of deletion" 2506, and sends the signal showing objects to be deleted in "display unit" 2507, and wait for operator instructions. When the deletion instruction form "input unit" 2508 is sent to the "means for acceptability check of deletion" 2506, and to the "simple deletion means" 2509, the system delete all model components with deletion candidates labels in "communication network model holding unit" 2501.

### 〈〈Section 18: The Apparatus for Searching and Accumulating Characteristic Values〉〉

FIG. 26 illustrates the structure of the apparatus for searching and accumulating characteristic values. Logical models are stored in the "logical model holding unit" 2601 and are shown with model components thereof in "display unit" 2607.

The system analyzes the signal from "input unit" 2608 by the "means for detecting instructions for search and accumulation" 2602. Detecting the signal with model component and characteristic value assigned, the system sends a signal to the means checking that the assigned model component has data of the characteristic value" 2603. If this components has data of the characteristic value, the system send a signal to the "means for showing data in display unit" 2605. As a result, the answer to the instructing signal for search and accumulation is shown.

If there is no data of the characteristic value, the system sends a signal to the "means for send a signal instructing re-search and re-accumulation" 2606. By this means, the system assigns another model component that supports the realization of the formerly assigned model components, and sends the signal instructing the search and accumulation to the `means for detecting instructions for search and accumulation" 2602. The former assigned model component is the caller model components for this newly assigned model component with data indicating the caller.

When the system find data of the characteristic value, by the "means checking that the assigned model component has data of the characteristic value" 2603, the system sends a signal to another means confirming the data of caller model component. Another means is the "means reporting the value to the caller model component" 2604. Thus the system reports to the caller.

If there are several reports to the caller model component, means (defined for the said model component) launches the "means accumulating reported values" 2609 and accumulates reported values thereof, and sets the accumulated value as the temporary value (work data) of the characteristic value of the model component. If the caller model component is set, the system reports the said temporary value.

The "display unit" 2607 shows (by the means defined in the said model component) the temporary value (work data) of the characteristic in the model component that was first assigned. This is the answer to the original signal for search and accumulation

After completing the above process for searching and accumulating characteristic values, temporary data within the said model component, such as the work memory showing the caller model component and the temporary value (work data), of the characteristic value are cleared. This final means for clearing temporary data is omitted in FIG.26.

### 〈〈Section 19: The Apparatus for Evaluating the Effect of Changing Characteristic Values〉〉

FIG. 27 illustrates apparatus for evaluating the effect of changing characteristic values. The phrases "logical model holding unit" 2601, "input unit" 2608, and "means for detecting the instruction for search and accumulation" 2602 in FIG.27 are also used respectively in FIG. 26.

The system analyze a signal from "input unit" 2608 by is "means for detecting the instruction for evaluating the effect of characteristic values" 2701. When the system detects a signal which assigns the model component and the characteristic value and invokes evaluation of the effect of changing characteristic values, the system sends a signal to the "means for discriminating the model component whose realization is directly supported by the assigned model component" 2702. And the "means for transmitting the instruction signal for search and accumulation for the assigned model component and characteristic value" 2703 is launched. The signal from this means is transmitted to the "means for detecting the instruction for search and accumulation" 2602. This means is that of FIG. 26 and a series of actions described in Section 18 are launched.

In the "means for discriminating the model component whose realization is directly supported by the assigned model component" 2702 and the "means for transmitting the instruction signal for search and accumulation for the assigned model component and characteristic value" 2703, the system accesses data of logical models that are stored in the "logical model storing unit" 2601, and retrieves the characteristic value and the relationship that supports the realization. The system writes-in the characteristic value that could be retrieved by evaluating the effect of changing characteristic values.

### 〈〈Section 20: Explanation of Claims〉〉

Claims 1 to 4 relate to methods for connecting logical models by using service model components. Claim 5 relates to the method for handling the relevant service model component for detouring or overflowing traffic. Claim 6 relates to the method for using the core model component. Claims 7 to 11 relate to methods for providing service model components. Claim 12 relates to the method for deleting, and Claim 13 relates to the method for searching, and Claim 14 relates to the method for evaluating the effect of changing characteristic values.

Claims 15 to 28 relate to computer-readable media in which the program that realized the above methods are recorded, and Claims 15 to 28 correspond to Claims 1 to 14 respectively. The computer-readable medium is described in Section 7.1.

Claims 29 to 36 relate to the apparatus and claims 29 to 33 correspond to Claims 1 to 5 respectively. Claim 34 relates to the apparatus for deleting, and Claim 35 relates to the apparatus for searching, and Claim 36 relates to the apparatus for evaluating the effect of changing characteristic values.

Claims 37 to 42 relate to computer-readable medium that has recorded logical models generated by all the aforementioned methods and apparatus.

### INDUSTRIAL APPLICABILITY

As has already been made clear, the method and apparatus for generating logical models by the present invention can be used to generate a plurality of logical models associated with each other, in relation to service request and provision without contradiction. The logical model that the computer handles includes the design drawings of communications networks, transportation plans, human or organizational interrelationship diagrams and the like, in addition to architectural design drawings and automobile diagrams. The present invention is applicable to a wide range of industries.

Even if the service that is realized (the service whose realization is supported) in cooperation of a plurality of model components cannot be defined as a model component per se, a logical model can be generated (or designed) without much difficulty regardless, when there is only one logical model to be designed. However, when a plurality of logical models are interrelated in service request and provision, these logical models cannot be generated consistently and utilized without the use of service model components.

As a logical model is composed in association with model components by references, and the system can access the said model components of other relevant logical models by tracing these references, "deleting model components without any contradictions" and "searching characteristic values and evaluating the effect of changing characteristic values accurately according to the structure of the said logical model" have been made possible.

The present invention also includes computer-readable media that has recorded a logical model generated by the method, the apparatus for generating logical models of the present invention, and the program itself that realized the method of the present invention.

## Claims

1. A method for generation a logical model by connecting model components by a reference, comprising:
a process for setting a reference between a service model component and a logical model, which is the provider side logical model, and
a process for setting a reference between said service model component and a logical model, which is the user side logical model.

2. The method for generating a logical model according to Claim 1, comprising:
a process for connecting the service model component and a model component which supports realization thereof by a reference, and
a process for connecting the model component and a service model component which supports realization thereof by a reference.

3. The method for generating a logical model according to Claim 2, comprising:
a process for connecting the service model component and a model component which supports realization thereof by a reference in both directions, and
a process for connecting the model component and a service model component which supports realization thereof by a reference in both directions.

4. A method for generating a logical model by connecting model components by a reference, comprising:
a process for setting a reference between a PSMC (standing for provision service model component) and a logical model, which is the provider side logical model,
a process for setting a reference between a RSMC (standing for request service model component) and a logical model, which is the user side logical model, and
a process for setting a reference between the RSMC and the PSMC.

5. A method for generating a logical model by connecting model components by a reference, comprising:
a process for generating a new service model component corresponding to a traffic caused by detouring or overflowing, and
a process for setting a reference between the service model component and a model component which supports realization thereof.

6. A method for generating a logical model by connecting model components by a reference comprising:
a process for setting a reference between a logical model and a core model component thereof which provides a service model component which supports realization of said logical model, and
a process for connecting the core model component and the model component which is a constituent element of the logical model by a reference or series of references.

7. A method for generating a logical model by connecting model components by a reference, comprising:
a process for generating a service model component according to a provision service data, and
a process for setting a reference between a logical model, which is the target logical model to generate an actual sub model but is still the service-provider logical model at that time, and the generated service model component.

8. A method for generating a logical model by connecting model components by a reference, comprising:
a process for setting a reference between a link model component of a service sub model and a service model provided for the area, and
a process for generating a new node model component corresponding to the starting point or the ending point of a service model component provided by a logical model, and for adding said node model component to service sub models of the logical model.

9. The method for generating a logical model according to Claim 8, comprising: a process for generating the link model component corresponding to the service model component provided by the logical model, and for adding the link model component to service sub models of the logical model.

10. A method for generating a logical model by connecting model components by
a reference, comprising:
a process for refusing to provide the service model component, to which there is no link model component corresponding, and
a process for providing a service model component according to a provision service data assigned in a logical model.

11. A method for generating a logical model by connecting model components by
a reference, comprising:
a process for refusing to provide the service model component, to which there is no link model component corresponding, and
a process for providing a service model component according to a provision service data assigned in a link model component.

12. A method for utilizing a logical model comprising of model components, which are interconnected by a reference, comprising:
a process for setting a deletion candidate label in a model component assigned as a deletion candidate, and
a process for determining whether or not the logical model is the adjunct deletion candidate from a deletion candidate label of a logical model connected with the former logical model.

13. A method for utilizing a logical model comprising of model components which
are interconnected by a reference, comprising:
(a) a process for determining whether or not data of an assigned characteristic value is set in a model component, and
(b) a process for reporting data of the characteristic value to a caller model component when there are data thereof, and
(c) a process for sequentially selecting a model component which directly supports realization of said model component when there are no data of the characteristic value, and
(d) a process for assigning the selected model component and launching recursively the above-mentioned processes starting from (a), and
(e) a process for accumulating said reported value and reporting said accumulated data as a to the caller model component.

14. A method for utilizing a logical model comprising of model components, which are interconnected by a reference, and for searching a characteristic value, comprising:
(a) a process for determining whether or not data of an assigned characteristic value is set in a component, and
(b) a process for reporting data of the characteristic value to a caller model component when there are data thereof, and
(c) a process for sequentially selecting a model component which directly supports realization of said model component when there are no data of the characteristic value, and
(d) a process for assigning the selected model component and launching recursively the above-mentioned processes starting from (a), and
(e) a process for accumulating said reported value and reporting said accumulated data as a result to the caller model component, and further comprising:
(1) a process for discriminating a logical model whose realization is directly supported by an assigned logical model, and
(2) a process for calling (a) (b) (c) (d) (e) assigning a logical model and a characteristic value, they implement a process for searching a characteristic value of a model component.

15. A computer readable medium which recorded a method for generating a logical model by connecting model components by a reference, comprising:
a process for setting a reference between a service model component and a logical model, which is the provider side logical model,
a process for setting a reference between the service model component and a logical model, which is the user side logical model.

16. The computer readable medium which recorded the method for generating a logical model according to Claim 15, comprising:
a process for connecting the service model component and a model component which supports realization thereof by a reference,
a process for connecting the model component and a service model component which supports realization thereof by a reference.

17. The computer readable medium which recorded the method for generating a logical model according to Claim 16, comprising:
a process for connecting the service model component and a model component which supports realization thereof by a reference in both directions,
a process for connecting the model component and a service model component which supports realization thereof by a reference in both directions.

18. A computer readable medium which recorded a method for generating a logical model by connecting model components by a reference, comprising:
a process for setting a reference between a PSMC and a provider side logical model,
a process for setting a reference between a RSMC and a user side logical model, and
a process for setting a reference between the PSMC and the RSMC.

19. A computer readable medium which recorded a method for generating a logical model by connecting model components by a reference, comprising:
a process for generating a new service model component corresponding to a traffic caused by detouring or overflowing, and
a process for setting a reference between the service model component and a model component which supports realization thereof.

20. A computer readable medium which recorded a method for generating a logical model by connecting model components by a reference, comprising:
a process for setting a reference between a logical model and a core model component thereof which provides a service model component which supports realization of said logical model, and
a process for connecting the core model component and a model component which is a constituent element of the logical model by a reference or series of references.

21. A computer readable medium which recorded a method for generating a logical model by connecting model components by a reference, comprising:
a process for generating a service model component according to a provision service data, and
a process for setting a reference between a logical model which is the target logical model to generate an actual sub model but is still the service-provider logical model at that time, and the generated service model component.

22. A computer readable medium which recorded a method for generating a logical model by connecting model components by a reference, comprising:
a process for setting a reference between a link model component of a service sub model and a service model provided for the area, and
a process for generating a new node model component corresponding to the starting point or the ending point of a service model component provided by a logical model, and for adding said node model component to service sub models of the logical model.

23. The computer readable medium which recorded the method for generating a logical model according to Claim 22, comprising:
a process for generating a link model component corresponding to the service model component provided by the logical model, and for adding said link model component to service sub models of the logical model.

24. A computer readable medium which recorded a method for generating a logical model by connecting model components by a reference, comprising:
a process for refusing to provide the service model component, to which there is no link model component corresponding, and
a process for providing a service model component according to a provision service data assigned in a logical model.

25. A computer readable medium which recorded a method for generating a logical model by connecting mode! components by a reference, comprising:
a process for refusing to provide the service model component, to which there is no link model component corresponding, and
a process for providing a service model component according to a provision service data assigned in a link model component.

26. A computer readable medium which recorded the method for utilizing a logical model comprising of model components which are interconnected by a reference, comprising:
a process for setting a deletion candidate label in a model component assigned as an deletion candidate, and
a process for determining whether or not a logical model is an adjunct deletion candidate from a deletion candidate label of a logical model connected with the former logical model.

27. A computer readable medium which recorded the method for utilizing a logical model comprising of model components which are interconnected by a reference, comprising:
(a) a process for determing whether or not data of an assigned characteristic value is set in a model component, and
(b) a process for reporting data of the characteristic value to a caller model component when there are data thereof, and
(c) a process for sequentially selecting a model component which directly supports realization of said model component when there are no data of the characteristic value, and
(d) a process for assigning the selected model component and launching recursively the above-mentioned processes starting from (a), and
(e) a process for accumulating said reported value and reporting said accumulated data as a result to the caller model component.

28. A computer readable medium which recorded the method for utilizing a logical model comprising of model components, which are interconnected by a reference, and for searching a characteristic value, comprising:
(a) a process for determining whether or not data of an assigned characteristic value is set in a model component, and
(b) a process for reporting data of the characteristic value to a caller model component when there are data thereof, and
(c) a process for sequentially selecting a model component which directly supports realization of said model component when there are no data of the characteristic value, and
(d) a process for assigning the selected model component and launching recursively the above-mentioned processes starting from (a), and
(e) a process for accumulating said reported value and reporting said accumulated data as a result to the caller model component, and further comprising:
(1) a process for discriminating a logical model whose realization is directly supported by an assigned logical model, and
(2) a process for calling (a) (b) (c) (d) (e) assigning a logical model and a characteristic value, they implement a process for searching a characteristic value of a model component.

29. An apparatus for generating a logical model by connecting model components by a reference, comprising:
a process for setting a reference between a service model component and a logical mode, which is the provider side logical model, and
a process for setting a reference between the service model component and a logical model, which is the user side logical model.

30. The apparatus for generating a logical models according to Claim 29, comprising:
a process for connecting the service model component and a model component which supports realization thereof by a reference, and
a process for connecting the model component and a service model component which supports realization thereof by a reference.

31. The apparatus for generating a logical model according to Claim 30, comprising:
a process for connecting the service model component and a model component which supports realization thereof by a reference in both directions, and
a process for connecting the model component and a service model component which supports realization thereof by a reference in both directions.

32. An apparatus for generating a logical model by connecting model components by a reference, comprising:
a process for setting a reference between a PSMC and a provider side logical model, and
a process for setting a reference between a RSMC and a user side logical model, and
a process for setting a reference between the RSMC and the PSMC.

33. An apparatus for generating a logical model by connecting model components by a reference, comprising:
a process for generating a new service model component corresponding to a traffic caused by detouring or overflowing, and
a process for setting a reference between the service model component and a model component which supports realization thereof.

34. An apparatus for utilizing a logical model comprising of model components, which are interconnected by a reference, comprising:
(a) a means for setting a deletion candidate label to a model component assigned as a deletion candidate, and
(b) a means for determining whether or not a logical model is an adjunct deletion candidate from a deletion candidate label of a logical model connected with said logical model.

35. An apparatus for utilizing a logical model comprising of model components, which are interconnected by a reference, comprising:
(a) a means for determining whether or not data of an assigned characteristic value is set in a model component, and
(b) a means for reporting data of said characteristic value to a caller model component when there are data thereof, and
(c) a means for sequentially selecting a model component which directly supports realization of the model component in which there is no such data of the characteristic value, and
(d) a means for assigning the selected model component and launching recursively means from the above-mentioned (a), and
(e) a means for accumulating a reported value and reporting an accumulated data as a result to the caller model component.

36. An apparatus for utilizing a logical model comprising of model components, which are interconnected by a reference and for searching a characteristic value, comprising:
(a) a means for determining whether or not data of an assigned characteristic value is set in a model component, and
(b) a means for reporting data of said characteristic value to a caller model component when there are data thereof, and
(c) a means for sequentially selecting a model component which directly supports realization of the model component in which there is no such data of the characteristic value, and
(d) a means for assigning the selected model component and launching recursively means from the above-mentioned (a), and
(e) a means for accumulating said reported value and reporting said accumulated data as a result to the caller model component, and further comprising:
(1) a means for discriminating a logical model of which realization is directly supported by said assigned logical model, and
(2) a means for calling (a) (b) (c) (d) (e) assigning said logical model and the characteristic value, they implement a process for searching a characteristic value of a model component.

37. A computer readable medium which recorded a logical model whose model components are connected by a reference, comprising:
a reference between a service model component and a provider side logical model being set, and
a reference between the service model components and a user side logical model being set.

38. The computer readable medium which recorded a logical model according to Claim 37, comprising:
the service model component and a model component which supports the realization thereof being connected by a reference, and
the model component and a service model component which supports the realization thereof being connected by a reference.

39. The computer readable medium which recorded a logical model according to Claim 38, comprising:
the service model component and the model component which supports the realization thereof being connected by the reference in both directions, and
the model component and the service model component which supports the realization thereof being connected by the reference in both directions.

40. A computer readable medium which recorded a logical model whose model components are connected by a reference, comprising:
setting a reference between a PSMC and a provider side logical model, and
setting a reference between a RSMC and a user side logical model, and
setting a reference between the RSMC and the PSMC.

41. A computer readable medium which recorded a logical model whose model components are connected by a reference, comprising:
a service model component corresponding to a traffic caused by detouring or overflowing existing, and
a reference between the service model component and a model component which supports realization thereof. being set.

42. A computer readable medium which recorded a logical model whose model components are connected by a reference, comprising:
a reference between a logical model and a core model component thereof which provides a service model component which supports realization of said logical model being set, and
the core model component and a model component which is a constituent element of the logical model by a reference or series of references being connected.
